# EUROPEAN PATENT APPLICATION

(11) **EP 4 650 796 A1**
(43) Date of publication of application: **19.11.2025**
(21) Application number: 23916827.1
(22) Date of filing: 20.01.2023
(51) Int. Cl.: G01R 31/28, G01R 31/396

(54) **TEST METHOD AND TEST APPARATUS FOR CHIP, AND UPPER COMPUTER, CHIP AND DEVICE**

(71) Applicant: Contemporary Amperex Technology Co., Limited, Ningde, Fujian 352100 (CN)
(72) Inventor: ZHOU, Fangjie, Ningde, Fujian 352100 (CN); CHU, Le, Ningde, Fujian 352100 (CN); WU, Guoxiu, Ningde, Fujian 352100 (CN)
(74) Representative: Lorenz Seidler Gossel Part. mbB
(86) International application number: PCT/CN2023/073352
(87) International publication number: WO 2024/152349

(57) **Abstract**

A test method and test apparatus for a chip, an upper computer, a chip, and a device. The method includes: obtaining a test circuit which is built according to a hot-plugging test bench requirement, where the test circuit includes at least one battery module and at least one chip; connecting the at least one chip to the at least one battery module; and testing functions of the at least one chip.

## Description

### TECHNICAL FIELD

The present application relates to the field of battery management technologies, and in particular, to a test method and test apparatus for a chip, an upper computer, a chip, and a device.

### BACKGROUND

Energy conservation and emission reduction are the key to the sustainable development of the automobile industry. Electric vehicles, with their advantages of energy conservation and environmental protection, have emerged as an important component for the sustainable development in the automobile industry. For the electric vehicles, battery technology is also an important factor about their development.

In the field of battery management, various chips usually need to be used to sample a battery to collect various states of the battery. However, a chip used in the field of battery management often faces a scenario of hot-swapping or hot-plugging, and a more severe test is imposed on voltage withstanding performance of the chip. Therefore, a solution for effectively testing a chip is expected.

### SUMMARY

The present application is intended to resolve at least one of technical problems existing in the related art. Therefore, an objective of the present application is to provide a test method and test apparatus for a chip, and an upper computer, a chip and a device, so as to effectively test performance of the chip.

An example of a first aspect of the present application provides a test method for a chip, including: determining a configuration mode of a test circuit, where the test circuit includes at least one chip and at least one battery module, and the at least one chip is configured to be connected to the at least one battery module according to the configuration mode; connecting the at least one chip to the at least one battery module based on at least one working condition corresponding to the configuration mode; determining whether an operation termination condition is satisfied; and testing the performance of the at least one chip in response to determining that the operation termination condition is satisfied.

In the technical solution of this embodiment of the present application, a standard hot-plugging test device solution is provided, to standardize a hot-plugging test. In actual application, test differentiation between different chip manufacturers may be reduced, and a standardized and normalized chip test may be implemented.

In some embodiments, the test circuit further includes a switch matrix, the switch matrix is between the at least one chip and the at least one battery module, and the switch matrix is configured to connect the at least one chip to the at least one battery module according to the configuration mode; and the connecting the at least one chip to the at least one battery module includes: performing a closing operation used for closing at least two switches in the switch matrix.

According to such an embodiment, a chip test can be flexibly performed based on a switch matrix, a complex manual plugging process can be avoided, a required scenario and working condition can be flexibly simulated, and a hot-plugging function of an AFE can be tested accurately and quickly and closer to a realistic application situation.

In some embodiments, the at least one chip includes a first chip, the at least one battery module includes a first battery module, and the hot-plugging test bench requirements include a first configuration mode, where the first configuration mode indicates that the first chip is configured to be connected to corresponding switches of the switch matrix, to enable sampling channel lines of the first chip to be respectively connected to corresponding sampling leads of the first battery module when the corresponding switches are turned on.

According to such an embodiment, a normalized test based on a use scenario can be implemented. Particularly, a common chip use scenario can be simulated by enabling a configuration mode of a test circuit to be close to a chip use scenario, so that a relatively reliable test result can be obtained.

In some embodiments, in response to the determining that the test circuit is built according to a first configuration mode, the performing the closing operation includes: closing, if none of switches corresponding to remaining sampling channel lines other than a pair of sampling channel lines associated with a maximum battery potential difference in the first chip is closed, a pair of switches corresponding to the pair of sampling channel lines.

According to such an embodiment, for a simulated use scenario, a test can be further performed on a working condition occurring in an application scenario. Particularly, a test working condition corresponds to a configuration mode of the circuit, that is, a common working condition corresponding to a current use scenario of the chip can be simulated, thereby obtaining a realistic and reliable test result. According to such an embodiment, a maximum voltage difference on the chip may be caused by first closing switches of a pair of sampling channel lines associated with a maximum battery potential difference. Therefore, according to such an embodiment, a functional test of the chip is better facilitated by simulating a severest working condition, and a chip obtained after such a test still has satisfactory reliability even when dealing with an extreme working condition.

In some embodiments, in response to the determining that the test circuit is built according to a first configuration mode, the performing the closing operation further includes: randomly closing the switches corresponding to the remaining sampling channel lines in the first chip after the pair of switches corresponding to the pair of sampling channel lines are closed.

According to such an embodiment, for a simulated use scenario, a test can be further performed on a working condition occurring in an application scenario, and a common working condition corresponding to a use scenario of the chip is simulated, thereby obtaining a realistic and reliable test result. Specifically, after a severest working condition in which switches at two ends are first closed is simulated, remaining switches are randomly closed, so that not only a severe working condition can be covered, but also other common plug-in working conditions can be covered. In addition, a simulation result may be more realistic and comprehensive by using a logic of random closing.

In some embodiments, in response to the determining that the test circuit is built according to a first configuration mode, the performing the closing operation includes: randomly closing a switch corresponding to a sampling channel line of the first chip.

According to such an embodiment, for a simulated use scenario, by randomly closing switches corresponding to all sampling channel lines, a more common plugging working condition can be simulated, so that a simulation result is more realistic and comprehensive. In addition, a chip with a reliable function is obtained, thereby reducing possible faults in a use process of the chip.

In some embodiments, the at least one chip includes a first chip, the at least one battery module includes at least two battery modules connected in series, and the hot-plugging test bench requirements include a second configuration mode, where the second configuration mode indicates that the first chip is configured to be connected to corresponding switches of the switch matrix, to enable sampling channel lines of the first chip to be respectively connected to corresponding sampling leads of the at least two battery modules when the corresponding switches are turned on.

According to such an embodiment, a normalized test based on a use scenario can be implemented, to cover a scenario in which the quantity of sampling channel lines of the first chip is greater than the quantity of sampling leads of a single battery module or another scenario in which one chip may be used for sampling two or more batteries, thereby implementing realistic and reliable simulation and test of this common use scenario.

In some embodiments, in response to the determining that the test circuit is in a second configuration mode, the performing the closing operation includes: closing, if none of switches corresponding to sampling leads of a positive-electrode-side battery module of the at least two battery modules is closed, switches corresponding to sampling leads of remaining battery modules other than the positive-electrode-side battery module of the at least two battery modules; and closing a switch corresponding to a sampling lead associated with a highest battery potential of the positive-electrode-side battery module after the switches corresponding to the sampling leads of the remaining battery modules are closed for a first time delay.

According to such an embodiment, a working condition occurring in an application scenario can be further tested for a simulated use scenario, and a relatively severe working condition can be simulated for a scenario in which one chip is connected to two or more battery modules, thereby improving reliability of a chip obtained by using such a test method.

In some embodiments, the performing the closing operation further includes: randomly closing, after the switch corresponding to the sampling lead associated with the highest battery potential is closed, switches corresponding to remaining sampling leads other than the sampling lead associated with the highest battery potential of the positive-electrode-side battery module.

According to such an embodiment, for a simulated use scenario, a test can be further performed on a working condition occurring in an application scenario, and a simulation result may be more realistic and comprehensive by using a logic of random closing. Specifically, for the first simulation working condition of the second exemplary scenario, risks to be borne by sampling channel lines other than a sampling channel line that will bear a maximum voltage difference may be further simulated, so that risk test and evaluation can be performed on sampling channel lines and corresponding circuit parts of the chip, to obtain a more reliable test result.

In some embodiments, in response to the determining that the test circuit is in a second configuration mode, the performing the closing operation includes: closing, if none of switches corresponding to sampling leads of a negative-electrode-side battery module of the at least two battery modules is closed, switches corresponding to sampling leads of remaining battery modules other than the negative-electrode-side battery module of the at least two battery modules; and closing a switch corresponding to a sampling lead associated with a lowest battery potential of the negative-electrode-side battery module after the switches corresponding to the sampling leads of the remaining battery modules are closed for a second time delay.

According to such an embodiment, another relatively severe working condition can be simulated for a second scenario in which one chip is connected to two or more battery modules.

In some embodiments, the performing the closing operation further includes: randomly closing, after the switch corresponding to the sampling lead associated with the lowest battery potential is closed, switches corresponding to remaining sampling leads other than the sampling lead associated with the lowest battery potential of the negative-electrode-side battery module.

According to such an embodiment, for a simulated use scenario, a test can be further performed on a working condition occurring in an application scenario, and a simulation result may be more realistic and comprehensive by using a logic of random closing. Specifically, for the second simulation working condition of the second exemplary scenario, risks to be borne by sampling channel lines other than a sampling channel line that will bear a maximum voltage difference may be further simulated, to obtain a more reliable test result.

In some embodiments, the at least one chip includes a first chip and a second chip, the at least one battery module includes a first battery module, and the obtaining a test circuit which is built according to hot-plugging test bench requirements includes determining that the test circuit is built according to a third configuration mode, where the third configuration mode indicates that the first chip and the second chip are configured to be connected to corresponding switches of the switch matrix, to enable the first chip and the second chip to be connected to corresponding sampling leads of the first battery module when the corresponding switches are turned on.

According to such an embodiment, a scenario in which the quantity of sampling channel lines of the first chip is less than the quantity of sampling leads of a single battery module or another scenario in which two or more chips may be used for sampling a single battery can be covered, thereby implementing realistic and reliable simulation and test of this common use scenario.

In some embodiments, a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and in response to the determining that the test circuit is built according to a third configuration mode, the performing the closing operation includes: closing switches corresponding to the first sampling channel line and the second sampling channel line if none of switches corresponding to remaining sampling channel lines of the first chip and the second chip other than the first sampling channel line and the second sampling channel line is closed; and closing a switch corresponding to the third sampling channel line and a switch corresponding to the fourth sampling channel line after the switches corresponding to the first sampling channel line and the second sampling channel line are closed for a third time delay.

According to such an embodiment, a test effect and reliability of a chip obtained through a test can be improved by simulating a severe scenario, and a chip obtained after such a test still has satisfactory reliability even when dealing with an extreme working condition.

In some embodiments, the performing the closing operation further includes: randomly closing switches corresponding to remaining sampling channel lines of the first chip and the second chip other than the first sampling channel line, the second sampling channel line, the third sampling channel line, and the fourth sampling channel line after the switch corresponding to the third sampling channel line and the switch corresponding to the fourth sampling channel line are closed.

According to such an embodiment, for a simulated use scenario, a test can be further performed on a working condition occurring in an application scenario; and a simulation result may be more realistic and comprehensive by using a logic of random closing. In other words, for the first simulation working condition of the third exemplary scenario, risks to be borne by sampling channel lines other than a sampling channel line that will bear a maximum voltage difference may be further simulated, to fully test the tolerance of the chip.

In some embodiments, in response to the determining that the test circuit is built according to a third configuration mode, the performing the closing operation includes: randomly closing switches corresponding to sampling channel lines of the first chip and the second chip.

According to such an embodiment, in addition to the provided severest working condition, other working conditions that are more common in practice may be further simulated in a test. According to such an embodiment, other common plugging working conditions can be covered. In addition, a simulation result may be more realistic by using a logic of random closing, and therefore a reliable and comprehensive test result is obtained.

In some embodiments, a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and the third configuration mode further indicates that the first sampling channel line is electrically connected to the second sampling channel line.

According to such an embodiment, an exemplary scenario in which the chip is short-circuited in advance can be further considered, so that scenarios that the chip may face can be covered more comprehensively, thereby obtaining a reliable test result.

In some embodiments, in response to the determining that the test circuit is built according to a third configuration mode, the performing the closing operation includes: closing switches corresponding to sampling channel lines of the second chip if none of switches corresponding to sampling channel lines of the first chip is closed; and closing a switch corresponding to the third sampling channel line after the switches corresponding to the sampling channel lines of the second chip are closed for a third time delay.

According to such an embodiment, a severe working condition that can be withstood during hot-swapping when the chip is short-circuited can be simulated, so as to obtain a reliable test result.

In some embodiments, the performing the closing operation further includes: randomly closing switches corresponding to remaining sampling channel lines of the first chip other than the third sampling channel line after the switch corresponding to the third sampling channel line is closed.

According to such an embodiment, other common plugging working conditions and sampling channel lines can be covered, so that risk test and evaluation can be performed on sampling channel lines and corresponding circuit parts of the chip, to obtain a more reliable test result.

In some embodiments, the operation termination condition includes at least one of the following: a quantity of execution times of a closing operation for the at least one chip reaches a first threshold, or a quantity of execution times of a closing operation based on a particular configuration mode reaches a second threshold for the particular configuration mode.

According to such an embodiment, chip testing can be further normalized by defining a termination condition.

In some embodiments, the test method further includes in response to determining that an operation termination condition is not satisfied: performing a power-off operation on the at least one chip; discharging a capacitor in the at least one chip; and repeatedly performing the steps of performing a closing operation used for closing at least two switches in the switch matrix and testing functions of the at least one chip, where the operation termination condition includes at least one of the following: a quantity of execution times of a closing operation for the at least one chip reaches a first threshold, or a quantity of execution times for each working condition of the at least one working condition reaches a second threshold for the working condition.

According to such an embodiment, impact of capacitor charging can be reduced, thereby obtaining a more realistic test effect.

In some embodiments, the test method further includes: regulating, in response to that the step of determining that the at least one chip is connected to the at least one battery module is performed for the first time, a cell voltage of a battery in the at least one battery module to a specified value before the testing functions of the at least one chip. According to such an embodiment, stability of the test can be ensured.

In some embodiments, the test method further includes the testing functions of the at least one chip includes performing a supply voltage range test on the at least one chip.

An example of a second aspect of the present application provides a test apparatus for a chip, including: at least one battery module; a switch matrix; and an upper computer, where the upper computer is configured to control an operation on at least one switch in a switch matrix, the switch matrix is configured to connect at least one chip to at least one battery module, and the upper computer is configured to perform the method according to the embodiments of the present application.

In some embodiments, the test apparatus further includes at least one discharging unit, where the at least one discharging unit is configured to discharge a corresponding capacitor in the at least one chip when the at least one discharging unit is switched on.

According to such an embodiment, impact of capacitor charging can be reduced, thereby obtaining a more realistic test effect.

An embodiment of a third aspect of the present application provides an upper computer, where the upper computer is configured to control an operation on at least one switch in a switch matrix, the switch matrix is configured to connect at least one chip to at least one battery module, and the upper computer is configured to perform the method according to the embodiments of the present application.

An embodiment of a fourth aspect of the present application provides a chip for a battery, where the chip is tested by using the method according to the embodiments of the present application.

An embodiment of a fifth aspect of the present application provides an electronic device, including: at least one processor; and a memory communicatively connected to the at least one processor, where the memory stores an instruction executable by the at least one processor, and the instruction is executed by the at least one processor, to enable the at least one processor to perform the method according to the embodiments of the present application.

An embodiment of a sixth aspect of the present application provides a non-transitory computer-readable storage medium storing a computer instruction, where the computer instruction is used for causing the computer to perform the method according to the embodiments of the present application.

The above descriptions only refer to an overview of the technical solution of the present application. To understand the technical means of the present application more clearly, it can be implemented according to the content of the descriptions. To make the foregoing and other objectives, features and advantages of the present application more apparent, the specific implementations of the present application are listed below.

### BRIEF DESCRIPTION OF THE DRAWINGS

In the drawings, unless otherwise specified, same reference numerals throughout multiple drawings represent same or similar parts or elements. These drawings are not necessarily drawn to scale. It should be understood that these drawings only describe some embodiment disclosed according to the present application, and should not be construed as limitations to the scope of the present application.
FIG. 1 is a schematic structural diagram of a vehicle according to some embodiments of the present application;
FIG. 2 is a schematic exploded structural view of a battery according to some embodiments of the present application;
FIG. 3 is a schematic exploded structural view of a battery cell according to some embodiments of the present application;
FIG. 4 is a schematic flowchart of a test method for a chip according to some embodiments of the present application;
FIG. 5 is a schematic diagram of a test circuit according to some embodiments of the present application;
FIG. 6 is a schematic diagram of a test circuit according to some other embodiments of the present application;
FIG. 7 is a schematic diagram of a test circuit according to still some other embodiments of the present application;
FIG. 8 is a schematic diagram of a test circuit according to yet some other embodiments of the present application;
FIG. 9 is a schematic diagram of a test apparatus according to some embodiments of the present application;
FIG. 10 is a schematic diagram of a computer device according to some embodiments of the present application;
FIG. 11 is a schematic diagram of a test circuit according to some other embodiments of the present application;
FIG. 12 is a schematic diagram of a test circuit according to still some other embodiments of the present application;
FIG. 13 is a schematic diagram of a test circuit according to yet some other embodiments of the present application;
FIG. 14 is a schematic diagram of a test circuit according to yet still some other embodiments of the present application.

Descriptions of reference numerals:
vehicle 1000;
battery 100, controller 200, and motor 300;
box 10, first part 11, and second part 12;
battery cell 20, end cover 21, electrode terminal 21a, case 22, cell assembly 23, and tab 23a;
test circuit 500, first battery module 510, switch matrix 520, first chip 530, sampling leads 510-1, 510-2, 510-3, ..., and 510-N, switches 520-1, 520-2, 520-3, ..., and 520-N, and sampling channel lines 530-1, 530-2, 530-3, ..., and 530-N;
test circuit 600, first battery module 611, second battery module 612, switch matrix 620, first chip 630, sampling leads 610-1, 610-n, 610-(n+1), ..., and 610-N, switches 620-1, 620-n, 620-(n+1), ..., and 620-N, and sampling channel lines 630-1, 630-n, 630-(n+1), ..., and 630-N;
test circuit 700, first battery module 710, switch matrix 720, first chip 731, second chip 732, sampling leads 710-**1,** 710-n, 710-(n+1), ..., and 710-N, switches 720-1, 720-n, 720-(n+1), ..., and 720-N, and sampling channel lines 730-1, 730-n, 730-(n+1), ..., and 730-N;
test circuit 800, first battery module 810, switch matrix 820, first chip 831, second chip 832, sampling leads 810-1, 810-n, 810-(n+1), ..., and 810-N, switches 820-1, 820-n, 820-(n+1), ..., and 820-N, and sampling channel lines 830-1, 830-n, 830-(n+1), ..., and 830-N;
test circuit 900, first battery module 910, switch matrix 920, first chip 930, upper computer 940, sampling leads 910-1, 910-2, 910-3, ..., and 910-N, switches 920-1, 920-2, 920-3, ..., and 920-N, and sampling channel lines 930-1, 930-2, 930-3, ..., and 930-N;
electronic device 1000;
test circuit 1100, at least one battery module 1110, switch matrix 1120, at least one chip 1130, upper computer 1140, discharging unit 1150, chips 1131 and 1132, and battery modules 1111 and 1112;
test circuit 1200, at least one battery module 1210, switch matrix 1220, at least one chip 1230, upper computer 1240, discharging unit 1250, chip 1231, and battery modules 1211 and 1212;
test circuit 1300, at least one battery module 1210, switch matrix 1320, at least one chip 1330, upper computer 1340, discharging unit 1350, chips 1331 and 1332, and battery module 1311; and
test circuit 1400, at least one battery module 1210, switch matrix 1420, at least one chip 1430, upper computer 1440, discharging unit 1450, chips 1431 and 1432, and battery module 1411.

### DETAILED DESCRIPTION

Embodiments of the technical solutions of the present application will be described in detail below with reference to the accompanying drawings. The following embodiments are only used to illustrate the technical solutions of the present application more explicitly, and are thus only interpreted as examples, rather than used to limit the protection scope of the present application.

Unless otherwise defined, all technical and scientific terms used in this specification have same meanings as those commonly understood by a person skilled in the art to which the present application belongs. The terms used in this specification are only intended to describe specific embodiments, and are not intended to limit the present application. The terms "include", "include", and any variants thereof in the specification and claims of the present application and the foregoing accompanying drawings are intended to cover non-exclusive inclusion.

In the descriptions of the embodiments of the present application, the technical terms "first", "second", and the like are only used to distinguish different objects, and should not be understood as indicating or implying relative importance or implying the quantity, specific order or primary and secondary relationship of indicated technical features. In different embodiments of the present application, objects described by "first", "second", and the like should not be considered as same objects all the time. For example, a "first chip" described in an embodiment of the present application may correspond to a "second chip" in another embodiment, and a "first battery module" described in an embodiment of the present application may correspond to a "second battery module" or a "third battery module" in another embodiment. In the description of the embodiments of the present application, "a plurality of" means two or more, unless otherwise expressly and specifically defined.

Reference in this specification to "an embodiment" means that a specified feature, structure, or characteristic described with reference to the embodiment may be included in at least one embodiment of the present application. Appearances of the phrase in various locations in this specification are not necessarily all referring to a same embodiment, nor are separate or alternative embodiments mutually exclusive of another embodiment. It is explicitly and implicitly understood by a person skilled in the art that embodiments described in this specification may be combined with another embodiment.

In the descriptions of the present application, the term "and/or" is merely an association to describe the associated objects. It can mean that there are three kinds of relationships, such as A and/or B, which means that A exists alone, A and B exist at the same time, and B exists alone. In addition, the character "/" in this specification generally indicates an "or" relationship between the associated objects.

In the descriptions of the embodiments of the present application, the term "a plurality of" means two or more (including two). Similarly, "a plurality of groups" means two or more groups (including two groups), and "a plurality of pieces" means two or more pieces (including two pieces).

In the description of the embodiments of the present application, orientation or position relationships indicated by the technical terms such as "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", and "circumferential" are based on orientation or position relationships shown in the accompanying drawings, and are only for the convenience of describing the present application and simplifying the description, rather than indicating or implying that the indicated device or element must have a specific orientation or must be configured and operated in a specific orientation. Therefore, such terms should not be construed as a limitation to the embodiments of the present application.

In the descriptions of the embodiments of the present application, unless otherwise expressly specified and defined, the technical terms "mounted", "connected to", "connected with", "fixed", or the like should be interpreted in a broad sense. For example, a connection may refer to a fixed connection, a disassembly connection or an integral connection; or may refer to a mechanical connection or an electrical connector; or may refer to a direct connection or an indirect connection through an intermediate medium; or may refer to an internal communication between the two elements or the interaction relationship between the two elements. For those skilled in the art, the specific meanings of the above terms in the embodiments of the present application may be interpreted according to the specific situations.

### //Overview of an inventive thread

Nowadays, from the perspective of development of the market situation, power batteries are applied increasingly. The power batteries are not only used in energy storage power systems such as water power plants, fire power plants, wind power plants and solar power plants, but also in electric transportations such as electric bicycles, electric motorcycles, and electric vehicles, as well as in military equipment, aerospace and other fields. With continuous expansion of the application fields of the power batteries, market demands for the power batteries are also expanding.

In the field of battery management, various chips, including but not limited to an analog front-end chip, usually need to be used to manage and sample a battery. For example, the chip may be used to collect information such as a cell voltage and a temperature of the battery, or the chip may be used to support a balancing function of the battery. Therefore, a chip having a stable function is very important.

However, the applicant notes that a chip used in the field of battery management usually faces a hot-plugging scenario. This is especially because the chip itself needs to be connected to the battery, the battery is used as a power supply, and there is usually a voltage difference between different pins of the battery. Therefore, a more severe test is imposed on the functions of the chip.

The applicant further notes that currently there is no effective solution of performing a hot-plugging test on an analog front-end chip used for sampling in the field of battery management systems. Lack of an effective test solution may cause faults in terminal applications. In addition, the applicant notes that in existing incomplete individual test solutions, working condition simulation is usually performed by manually pressing to connect or disconnect, which requires much labor participation, and is not flexible and comprehensive enough.

Therefore, the applicant finds by researches that a test method that can be used for hot-plugging working conditions of a plurality of application scenarios can be designed to implement a flexible chip test.

Based on the foregoing consideration, to fully verify hot-plugging performance of a chip at a chip design end, a test method for a chip is provided, including: determining a configuration mode of a test circuit, where the test circuit includes at least one chip, at least one battery module, and a switch matrix, the switch matrix is between the at least one chip and the at least one battery module, and the switch matrix is configured to connect the at least one chip to the at least one battery module according to the configuration mode; performing, based on the configuration mode, a closing operation used for closing at least two switches in the switch matrix; determining whether an operation termination condition is satisfied; and Test the performance of the at least one chip in response to determining that the operation termination condition is satisfied.

According to such a test solution, a standardized hot-plugging test can be obtained, and hot-plugging performance of a chip can be fully verified before the chip is put into use (for example, at a chip design end), thereby reducing occurrence of a chip exception in an application, and reducing terminal application losses.

### //Introduction of application scenarios

In the embodiments of the present application, a battery cell for a chip may be used in but is not limited to a power consuming apparatus such as a vehicle, a ship, or an aircraft. The electrical device using a battery as a power supply may be, but is not limited to, a mobile phone, a tablet computer, a notebook computer, an electric toy, a power tool, an electric bike, an electric vehicle, a ship, a spacecraft, or the like. The electric toy may include a fixed or mobile electric toy, for example, a game console, an electric automobile toy, an electric ship toy, and an electric airplane toy. The spacecraft may include an airplane, a rocket, a spacecraft, a spaceship, and the like.

For ease of description, the following embodiment is described by using an example in which a power consuming apparatus according to an embodiment of the present application is a vehicle 1000.

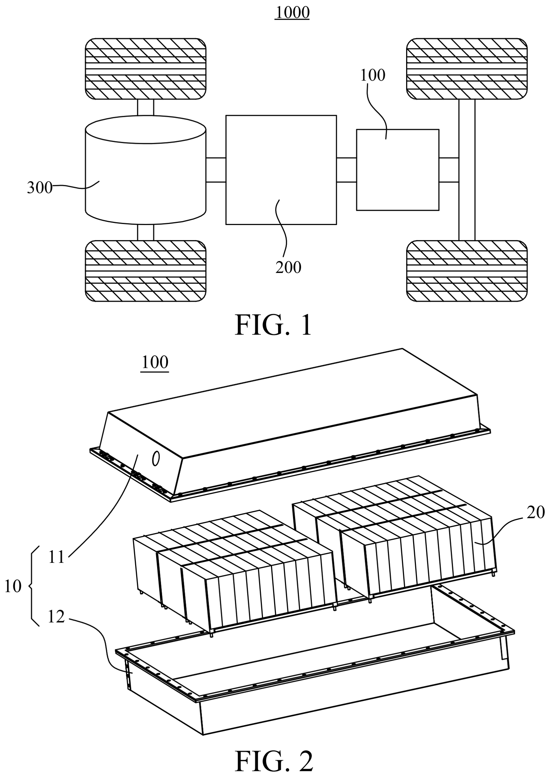

Referring to FIG. 1, FIG. 1 is a schematic diagram of a structure of a vehicle 1000 according to some embodiments of the present application. The vehicle 1000 may be a fuel powered vehicle, a gas powered vehicle, or a new energy vehicle. The new energy vehicle may be a pure electric vehicle, a hybrid electric vehicle, an extended range vehicle, or the like. A battery 100 is disposed inside the vehicle 1000, and the battery 100 may be disposed at a bottom, head, or tail of the vehicle 1000. The battery 100 may be configured to supply power to the vehicle 1000. For example, the battery 100 may be used as a power supply for operating the vehicle 1000. The vehicle 1000 may further include a controller 200 and a motor 300. The controller 200 is configured to control the battery 100 to supply power to the motor 300, for example, to meet operating electricity requirements during starting, navigation, and traveling of the vehicle 1000.

In some embodiments of the present application, the battery 100 may serve not only as an operating power supply of the vehicle 1000, but also as a driving power supply of the vehicle 1000, to alternatively or partially replace fuel or natural gas to provide driving power for the vehicle 1000.

Referring to FIG. 2, FIG. 2 is an exploded view of a battery 100 according to some embodiments of the present application. A battery 100 includes a box 10 and a battery cell 20, where the battery cell 20 is accommodated in the box 10. The box 10 is configured to provide an accommodating space for the battery cells 20. The box 10 may be of a variety of structures. In some embodiments, the box 10 may include a first part 11 and a second part 12, the first part 11 and the second part 12 cover each other, and the first part 11 and the second part 12 jointly define the accommodating space for accommodating the battery cells 20. The second part 12 may be a hollow structure being open on one side, the first part 11 may be a plate-like structure, and the first part 11 covers an open side of the second part 12, so that the first part 11 and the second part 12 jointly define the accommodating space. Alternatively, each of the first part 11 and the second part 12 may be a hollow structure being open on one side, and an open side of the first part 11 covers an open side of the second part 12. Certainly, the box 10 formed by the first part 11 and the second part 12 may be in various shapes, such as a cylinder and a cuboid.

In the battery 100, there may be a plurality of battery cells 20, and a plurality of battery cells 20 can be connected in series, parallel, or series-parallel. Series-parallel connection means that both series connection and parallel connection exist among the plurality of battery cells 20. The plurality of battery cells 20 may be directly connected in series, parallel, or series-parallel together, and then a whole formed by the plurality of battery cells 20 may be accommodated in the box body 10. Certainly, the battery 100 may alternatively be in the form of a plurality of battery modules formed by the plurality of battery cells 20 that are first connected in series, parallel, or series-parallel, and the plurality of battery modules are then connected in series, parallel, or series-parallel to form a whole and accommodated in the box body 10. The battery 100 may also include other structures, for example, the battery 100 may further include a bus component for implementing an electrical connection between the plurality of battery cells 20.

Each battery cell 20 may be a secondary battery or a primary battery, or may be a Li-S battery, a Na-ion battery, or a Mn-ion battery, but is not limited thereto. The battery cell 20 may be cylindrical, flat-shaped, cuboid-shaped, or in another shape.

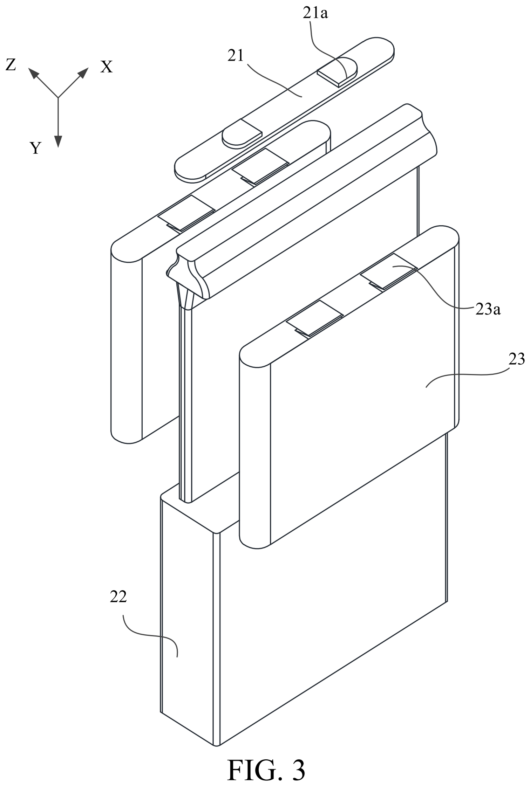

Referring to FIG. 3, FIG. 3 is a schematic diagram of an exploded structure of a battery cell 20 according to some embodiments of the present application. The battery cell 20 is a smallest unit forming a battery. As shown in FIG. 3, the battery cell 20 includes an end cover 21, a case 22, a cell assembly 23, and other functional components.

The end cover 21 refers to a component that covers an opening of the case 22 to isolate an internal environment of the battery cell 20 from an external environment. A shape of the end cover 21 is not limited and may be adapted to a shape of the case 22 to fit the case 22. According to some embodiments, the end cover 21 may be made of a material with specified hardness and strength (for example, aluminum alloy), so that the end cover 21 is less likely to be deformed under pressing and collision, to enable the battery cell 20 to have higher structural strength and enhanced safety performance. A functional component such as an electrode terminal 21a may be disposed on the end cover 21. The electrode terminals 21a may be configured to electrically connect to the cell assembly 23 to output or input electrical energy of the battery cell 20. In some embodiments, the end cover 21 may also be provided with a pressure relief mechanism configured to relieve internal pressure when the internal pressure or temperature in the battery cell 20 reaches a threshold. The end cover 21 may also be made of various materials, such as copper, iron, aluminum, stainless steel, aluminum alloy, and plastic, which are not particularly limited in the embodiments of the present application. In some embodiments, an insulator may also be arranged on an inner side of the end cover 21. The insulator can be configured to isolate electrical connection parts in the case 22 from the end cover 21, reducing a risk of short circuit. For example, the insulating member may be made of plastic, rubber, or the like.

The case 22 is an assembly configured to form an internal environment of the battery cells 20 together with the end cover 21, where the formed internal environment may be configured to accommodate the cell assembly 23, an electrolyte, and other components. The case 22 and the end cover 21 may be separate components, an opening may be provided in the case 22, and the end cover 21 covers the opening to form the internal environment of the battery cell 20. Without limitation, the end cover 21 and the case 22 may also be integrated. Specifically, the end cover 21 and the case 22 may form a shared connection surface before other components are arranged inside the case, and then the end cover 21 covers the case 22 when inside of the case 22 needs to be enclosed. The case 22 may be of various shapes and sizes, such as a rectangular shape, a cylindrical shape, and a hexagonal prism shape. Specifically, the shape of the case 22 may be determined based on a specific shape and size of the cell assembly 23. The case 22 may be made of various materials, such as copper, iron, aluminum, stainless steel, aluminum alloy, and plastic, which are not particularly limited in the embodiments of the present application.

The cell assembly 23 is a component in the battery cell 100 that undergoes electrochemical reactions. The case 22 may include one or more cell assemblies 23. The cell assembly 23 is mainly formed by winding or laminating a positive electrode plate and a negative electrode plate, and an isolating plate is generally provided between the positive electrode plate and the negative electrode plate. Parts of the positive electrode plate and the negative electrode plate with active substances form a body portion of the cell assembly, while parts of the positive electrode plate and the negative electrode plate without active substances separately form tabs 23a. A positive electrode tab and a negative electrode tab may be located at one end of the body portion together or at two ends of the body portion separately. During charging and discharging of the battery, a positive electrode active substance and a negative electrode active substance react with an electrolyte, and the tabs 23a are connected to the electrode terminals to form a current loop.

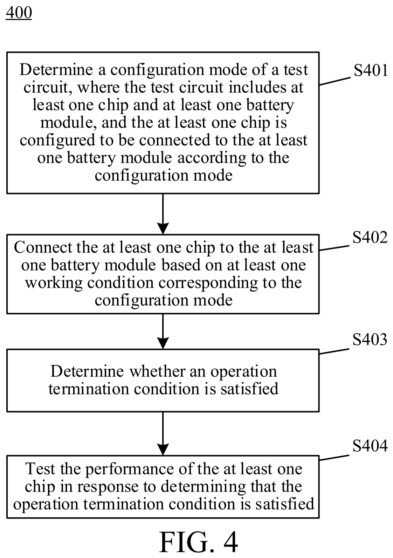

A test method 400 for a chip according to an embodiment of the present application will be described below with reference to FIG. 4. As shown in FIG. 4, the method 400 may include:

Step S401: Determine a configuration mode of a test circuit, where the test circuit includes at least one chip and at least one battery module, and the at least one chip is configured to be connected to the at least one battery module according to the configuration mode.

Step S402: Connect the at least one chip to the at least one battery module based on at least one working condition corresponding to the configuration mode.

In addition, it may be understood that, the configuration mode may be used to represent a simulated test scenario. A particular configuration mode of the circuit may be implemented, for example, by manually building a test bench, or in another manner. As an example, the configuration mode may be selected from a predetermined test mode set. As another example, the configuration mode may be selected according to an actual condition, for example, a quantity of sampling channel lines of the chip, a quantity of cells of the battery module, and a characteristic of a particular application scenario in which the chip is to be mounted.

According to this embodiment of the present application, a standard hot-plugging test device solution is provided, to standardize a hot-plugging test. In actual application, test differentiation between different chip manufacturers may be reduced, and a standardized and normalized chip test may be implemented.

Especially, according to this embodiment of the present application, a hot-plugging function of a chip can be fully verified before the chip is put into use (for example, at a chip design end), thereby reducing occurrence of a chip exception in an application, and reducing terminal application losses.

This embodiment of the present application may be applied to the field of battery management systems, and in particular, to a hot-plugging test of an analog front-end (AFE) chip, for example, an AFE chip that samples and manages a battery in a new energy automobile. Therefore, according to the method in this embodiment of the present application, design implementation and application of a terminal can be further accelerated, and healthy development of the new energy automobile industry can be further promoted.

In some embodiments, the method further includes testing performance of the at least one chip. In some embodiments, the method further includes: determining, before the testing performance of the at least one chip, whether an operation termination condition is satisfied; and Test the performance of the at least one chip in response to determining that the operation termination condition is satisfied.

It may be understood that, in some exemplary embodiments, when a working condition ends or a switch connection process ends, electrical data may be obtained to perform testing and verification. In some additional or optional exemplary embodiments, in each working condition or switch connection process, electrical data may also be obtained to perform testing and verification.

For example, the method may further include steps S403 and S404. Step S403: Determine whether an operation termination condition is satisfied.

Step S404: Test the performance of the at least one chip in response to determining that the operation termination condition is satisfied.

The satisfying the operation termination condition means that working condition simulation (for example, pressing or powering on) of the chip has been terminated, and a performance test may be performed on the chip. As a specific and non-limiting example of an operation termination condition, when a closing operation is completed, that is, at least two switches that need to be closed based on a current configuration mode are already closed (or are already closed for a specified time delay), it may be considered that the "operation termination condition" is satisfied. Other non-limiting examples of the operation termination condition are more specifically described below.

A process of testing the performance of the at least one chip may include various function and inspection performance tests of the chip that can be understood by a person skilled in the art, for example, and not limited to, one or more tests performed under a specific condition such as temperature or barometric pressure.

According to some embodiments, the method may include: obtaining a test circuit which is built according to a hot-plugging test bench requirement, where the test circuit includes at least one battery module and at least one chip; connecting the at least one chip to the at least one battery module; and testing functions of the at least one chip. The test circuit built according to the hot-plugging test bench requirement may be a test circuit built according to an expected circuit design, and may be used to simulate one or more expected simulation scenarios or working conditions. The test circuit built according to the hot-plugging test bench requirement may be used for connecting the at least one battery module to the at least one chip. However, it may be understood that, before the step of obtaining the test circuit, the battery module and the chip may not be connected, for example, are not ever connected, are once connected but disconnected, or are once connected but disconnected and fully discharged.

It may be understood that, the chip herein may be an Analog Front-end (AFE) chip, which may be configured to process an analog signal provided by a signal source and digitize the analog signal, and has modules such as an ADC, a multiplexer, and a state machine. More specifically, the chip herein may be an analog front-end chip used for an electric vehicle.

The at least one chip may be combined into a Cell Monitor Unit (CMU). The CMU may refer to a circuit module that is designed from an analog front-end chip according to a typical recommended circuit and that is obtained through production.

Hot-plugging may refer to hot-swapping, in which a module is plugged into or unplugged from a system without turning off a power supply of the system.

According to some embodiments, the test circuit further includes a switch matrix, the switch matrix is between the at least one chip and the at least one battery module, and the switch matrix is configured to connect the at least one chip to the at least one battery module according to the configuration mode; and the powering on the at least one chip includes: performing, based on at least one working condition corresponding to the test circuit, a closing operation used for closing at least two switches in the switch matrix.

It may be understood that, the statement that the switch matrix can "connect" the at least one chip to the at least one battery module according to at least one working condition corresponding to the test circuit (or, as described below, according to a configuration mode) neither requires that a corresponding switch of the switch matrix is already closed, and nor requires that the chip is already in a state of being electrically connected to the corresponding battery module when the configuration mode of the test circuit is determined. On the contrary, that the switch matrix is configured to connect the at least one chip to the at least one battery module according to the configuration mode may mean that, a first end of a corresponding switch of the switch matrix is connected to a corresponding connection point (for example, a corresponding sampling channel line) of the at least one chip, and a second end of the corresponding switch is connected to a corresponding connection point (for example, a corresponding sampling lead) of the at least one battery module of the at least one chip, so that when the corresponding switch is turned on, the chip may be connected to the battery module according to the expected configuration mode. At least two switches in the switch matrix are closed, so that the chip and the battery module are electrically connected, and a path can be formed between the chip and the battery module, thereby simulating a scenario of hot-swapping the chip.

In addition, it may be understood that, although the switch matrix is described herein, the present disclosure is not limited thereto, and the hot-plugging test according to the present disclosure may be implemented by using another technical means that can be understood by a person skilled in the art and that can connect a chip to a battery module.

According to this embodiment of the present application, a switch can be closed based on a configuration mode of the test circuit and a corresponding working condition, thereby implementing a normalized chip test solution.

According to this embodiment of the present application, by introducing the switch matrix into the configuration circuit, a complex manual plugging process can be avoided, a required scenario and working condition can be flexibly simulated, and a hot-plugging function of an AFE can be tested accurately and quickly and closer to a realistic application situation.

According to some embodiments, the performing a closing operation used for closing at least two switches in the switch matrix includes closing a switch in the switch matrix based on at least one of the following policies: a first policy, where the first policy is used for preferentially closing two switches of a power-on loop that form a maximum potential difference; or a second policy, where the second policy is used for preferentially closing a switch that is configured to form a path between the at least one battery module.

According to some embodiments, the at least one chip may include a first chip, and the at least one battery module may include a first battery module. In such an embodiment, the determining a configuration mode of a test circuit may include determining that the test circuit is in a first configuration mode, where the first configuration mode indicates that the first chip is configured to be connected to corresponding switches of the switch matrix, to enable sampling channel lines of the first chip to be respectively connected to corresponding sampling leads of the first battery module when the corresponding switches are turned on.

It may be understood that, the configuration mode may be used to represent a simulated test scenario. A particular configuration mode of the circuit may be implemented, for example, by manually building a test bench, or in another manner. as an example, the configuration mode may be selected from a predetermined test mode set. As another example, the configuration mode may be selected according to an actual condition, for example, a quantity of sampling channel lines of the chip, a quantity of cells of the battery module, and a characteristic of a particular application scenario in which the chip is to be mounted.

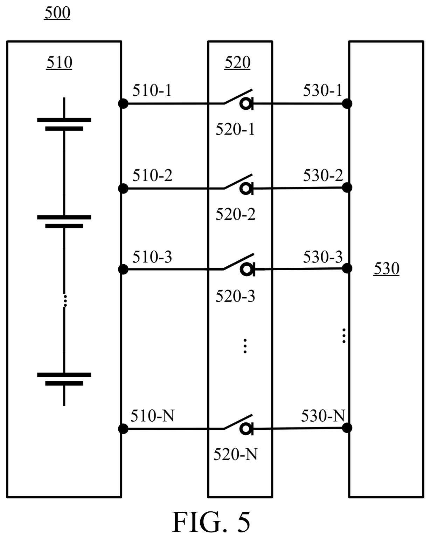

According to such an example, a common use scenario in which one chip is completely connected to one battery module can be simulated by using the first configuration mode, and is referred to as a first exemplary scenario herein for ease of description. As a specific example, a quantity of sampling channel lines of the first chip may be equal to a quantity of sampling leads of the first battery module. FIG. 5 is an exemplary diagram of a test circuit of a first configuration mode for a first exemplary scenario. As shown in FIG. 5, in a test circuit 500, a first chip 530 is configured to be connected to corresponding switches 520-1, 520-2, 520-3, ..., and 520-N of a switch matrix 520, so that when the corresponding switches 520-1, 520-2, 520-3, ..., and 520-N are turned on, sampling channel lines 530-1, 530-2, 530-3, ..., and 530-N of the first chip 530 can be respectively connected to corresponding sampling leads 510-1, 510-2, 510-3, ..., and 510-N of a first battery module 510.

It may be understood that, although FIG. 5 shows that the sampling channel lines of the first chip and the sampling leads of the first battery module are in a one-to-one correspondence, it may be understood that the present application is not limited thereto. As another non-limiting example, in such an embodiment, a quantity of sampling channels of the first chip may alternatively be less than a quantity of sampling leads of the battery module. For example, only some sampling leads of the battery module may be sampled.

In addition, it may be understood that, although FIG. 5 shows N switches configured to connect N sampling channel lines to N sampling leads, the quantity of N is not limited herein, as long as N is greater than or equal to 2 to form a voltage difference on the chip when corresponding switches are turned on.

According to such an embodiment, a normalized test based on a use scenario can be implemented. Particularly, a common chip use scenario can be simulated by enabling a configuration mode of a test circuit to be close to a chip use scenario, so that a relatively reliable test result can be obtained.

According to some embodiments, in response to the determining that the test circuit is in a first configuration mode, the performing the closing operation includes: closing, if none of switches corresponding to remaining sampling channel lines other than a pair of sampling channel lines associated with a maximum battery potential difference in the first chip is closed, a pair of switches corresponding to the pair of sampling channel lines.

Therefore, for the first configuration mode, that is, the first exemplary scenario expected to be simulated, a relatively severe use working condition in which a chip will bear a possible maximum voltage difference can be provided. For ease of description, and is referred to as a first simulation working condition for the first exemplary scenario herein. It may be understood that, a battery potential difference "associated with" a pair of sampling channel lines refers to a potential difference between a pair of sampling leads to which the pair of sampling channel lines is to be connected after corresponding switches are closed. In addition, it may be understood that, a pair of sampling channel lines being associated with a maximum battery potential difference means that among battery potential differences that can be associated with all sampling channel line pairs of the first chip, a battery potential difference associated with the pair of sampling channel lines is maximum. Still referring to FIG. 5, as a specific example, in an embodiment in which sampling channel lines of the first chip and sampling leads of the first battery are the same in quantity and are in a one-to-one correspondence, a pair of sampling channel lines associated with a maximum battery potential difference will be two sampling channel lines respectively to be connected to a sampling lead 510-1 closest to the positive electrode side and a sampling lead 510-N closest to the negative electrode side of the first battery, that is, 530-1 and 530-N shown in FIG. 5. In addition, in such an example, the switches 520-1 and 520-N may be preferentially closed before the remaining switches are closed.

It may be understood that, throughout this specification, a statement such as "close a pair of switches if none of remaining switches is closed", "close two switches if none of remaining switches is closed", "close two switches preferentially", or "close a pair of switches preferentially" that describes a closing sequence of two specific switches relative to a closing sequence of the remaining switches is not intended to limit a closing sequence of "a pair of switches" or "two switches", unless otherwise specified. On the contrary, such an expression may include, but is not limited to, the following scenarios: The two switches are closed at the same time, one of the two switches is closed first and the other is closed immediately, one of the two switches is closed first and the other is closed after a specified time delay or a random time delay, and so on, as long as it is ensured that closing moments of the two switches and the described "remaining switches" satisfy a particular relationship (for example, are earlier than the closing of the "remaining switches").

It may be further understood that, closing the pair of switches if none of switches corresponding to the remaining sampling channel lines is closed may refer to closing the pair of switches first or preferentially compared with the remaining switches. It may be understood that, such an expression does not require that in a subsequent closing operation, all switches except the pair of switches need to be closed, but only requires that the pair of switches is closed first. As a specific non-limiting example, it may be considered that this closing operation is terminated only after the pair of switches corresponding to the maximum potential difference is closed.

According to such an embodiment, for a simulated use scenario, a test can be further performed on a working condition occurring in an application scenario. Particularly, a test working condition corresponds to a configuration mode of the circuit, that is, a common working condition corresponding to a current use scenario of the chip can be simulated, thereby obtaining a realistic and reliable test result.

According to such an embodiment, a maximum voltage difference on the chip may be caused by first closing switches of a pair of sampling channel lines associated with a maximum battery potential difference. Therefore, according to such an embodiment, a performance test of the chip is better facilitated by simulating a severest working condition, and a chip obtained after such a test still has satisfactory reliability even when dealing with an extreme working condition.

According to some embodiments, in response to the determining that the test circuit is in a first configuration mode, the performing the closing operation further includes: randomly closing the switches corresponding to the remaining sampling channel lines in the first chip after the pair of switches corresponding to the pair of sampling channel lines are closed.

Therefore, in the first simulation working condition of the first exemplary scenario, closing of a switch other than that of a sampling channel line that will bear a maximum voltage difference may be further simulated. It may be understood that, the statement of random closing that is used throughout this specification may include any one of the following: A random closing sequence of switches, a random closing time delay between every two switches that are closed in sequence, or another random closing parameter that can be understood by a person skilled in the art. As a specific non-limiting example, the closing order may include any one or more of a forward sequence, a reverse sequence, a grouping disorder (for example, twosome grouping, threesome grouping, or foursome grouping), and a random number disorder.

Still referring to FIG. 5, as a specific non-limiting example, after the switches 520-1 and 520-N are closed, the switches 520-2, 520-3, ..., and the like may be randomly closed.

According to such an embodiment, for a simulated use scenario, a test can be further performed on a working condition occurring in an application scenario, and a common working condition corresponding to a use scenario of the chip is simulated, thereby obtaining a realistic and reliable test result.

Specifically, after a severest working condition in which switches at two ends are first closed is simulated, remaining switches are randomly closed, so that not only a severe working condition can be covered, but also other common plug-in working conditions can be covered. In addition, a simulation result may be more realistic and comprehensive by using a logic of random closing.

According to some embodiments, in response to the determining that the test circuit is in a first configuration mode, the performing the closing operation may include: randomly closing a switch corresponding to a sampling channel line of the first chip.

Therefore, for the first exemplary scenario, in addition to the provided severest working condition, another working condition that is more common in practice may be further simulated in a test, and is referred to as a second simulation working condition for the first exemplary scenario herein for ease of description.

Still referring to FIG. 5, as a specific non-limiting example, according to the second simulation working condition, the switches 520-1 to 520-N may be randomly closed, or at least two of the switches 520-1 to 520-N may be randomly closed.

It may be understood that, a closing operation according to this embodiment may be combined with a closing operation according to another embodiment of the present application. For example, for the first configuration mode, a closing operation of closing switches at two ends is performed first for the first simulation working condition one or more times, and for the same chip, a closing operation of randomly closing all switches is performed subsequently for the second simulation working condition one or more times, or vice versa. After the closing operation is performed each time, the switch may be opened. In addition, according to some embodiments, the chip may be discharged. Such an exemplary embodiment is further described below.

According to such an embodiment, for a simulated use scenario, a test can be further performed on a working condition occurring in an application scenario. Especially, a common working condition corresponding to a use scenario of the chip is simulated, thereby obtaining a realistic and reliable test result.

Especially, by randomly closing switches corresponding to all sampling channel lines, a more common plugging working condition can be simulated, so that a simulation result is more realistic and comprehensive. In addition, a chip with reliable performance is obtained, thereby reducing possible faults in a use process of the chip.

According to some embodiments, the at least one chip may include a first chip, the at least one battery module includes at least two battery modules connected in series, and the determining a configuration mode of a test circuit includes determining that the test circuit is in a second configuration mode, where the second configuration mode indicates that the first chip is configured to be connected to corresponding switches of the switch matrix, to enable sampling channel lines of the first chip to be respectively connected to corresponding sampling leads of the at least two battery modules when the corresponding switches are turned on.

According to such an example, a common use scenario in which one chip is connected to two or more battery modules can be simulated by using the second configuration mode, and is referred to as a second exemplary scenario herein for ease of description. It may be understood that, the at least two battery modules being connected in series may include: a negative electrode of a first battery module being connected to a positive electrode of a second battery module, a negative electrode of the second battery module being connected to a positive electrode of a third battery module, ..., and the like. The enabling sampling channel lines of the first chip to be respectively connected to corresponding sampling leads of the at least two battery modules may mean that a quantity of sampling channel lines of the first chip is greater than a quantity of sampling leads of a single battery module of the at least two battery modules. For example, a quantity of sampling channel lines of the first chip may be equal to a sum of quantities of sampling leads of the at least two battery modules.

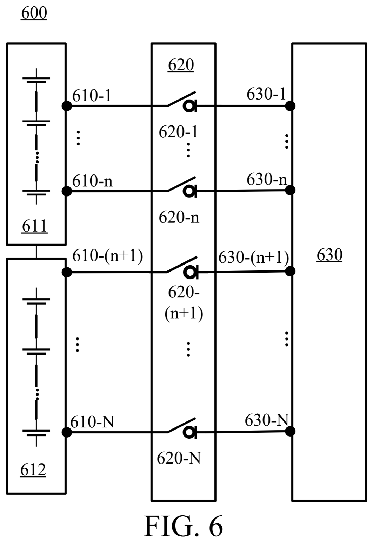

FIG. 6 shows an example of a second configuration mode for the second exemplary scenario. As shown in FIG. 6, in a test circuit 600, a first chip 630 is configured to be connected to corresponding switches 620-1, ..., 620-n, 620-(n+1), ... and 620-N of a switch matrix 620, so that when the corresponding switches 620-1, ..., 620-n, 620-(n+1), ... and 620-N are turned on, sampling channel lines 630-1, ..., and 630-n of the first chip 630 can be respectively connected to corresponding sampling leads 610-1, ..., and 610-n of a first battery module 611 of two battery modules 611 and 612 connected in series, and sampling channel lines 630-(n+1), ..., and 630-N of the first chip 630 can be respectively connected to corresponding sampling leads 610-(n+1), ..., and 610-N of a second battery module 612.

It may be understood that, although FIG. 6 shows that the at least one battery module includes two battery modules connected in series, more battery modules may be included. In addition, although FIG. 6 shows that the sampling channel lines of the first chip and sampling leads of two battery modules are in a one-to-one correspondence, it may be understood that the present application is not limited thereto. As another non-limiting example, in such an embodiment, a quantity of sampling channels of the first chip may alternatively be less than a sum of quantities of sampling leads of the battery modules. For example, only some sampling leads of the battery modules may be sampled.

In addition, it may be understood that, although FIG. 6 shows that the first chip includes N sampling channel lines that can be respectively connected to n sampling leads 610-1, ..., and 610-n of the first battery module 611 and (N-n) sampling leads of the second battery module 612, these values are not intended to be limiting. As a specific example, the first battery module 611 and the second battery module 612 may have a same quantity of sampling leads, for example, N = 2n. In another example, the first battery module 611 and the second battery module 612 (and according to some other embodiments, another battery module connected thereto in series) may have different quantities of sampling leads.

According to such an embodiment, a normalized test based on a use scenario can be implemented. Particularly, a common chip use scenario can be simulated by enabling a configuration mode of a test circuit to be close to a chip use scenario, so that a relatively reliable test result can be obtained.

Specifically, such an embodiment can cover a scenario in which the quantity of sampling channel lines of the first chip is greater than the quantity of sampling leads of a single battery module or another scenario in which one chip may be used for sampling two or more batteries, thereby implementing realistic and reliable simulation and test of this common use scenario. It may be understood that, in this second exemplary scenario, a maximum voltage that the chip can bear may be greater than a voltage of a single battery module. Therefore, it is very advantageous to cover such a scenario in a test.

According to some embodiments, in response to the determining that the test circuit is in a second configuration mode, the performing the closing operation may include: closing, if none of switches corresponding to sampling leads of a positive-electrode-side battery module of the at least two battery modules is closed, switches corresponding to sampling leads of remaining battery modules other than the positive-electrode-side battery module of the at least two battery modules; and closing a switch corresponding to a sampling lead associated with a highest battery potential of the positive-electrode-side battery module after the switches corresponding to the sampling leads of the remaining battery modules are closed for a first time delay.

According to such an embodiment, therefore, for the second configuration mode, that is, the second exemplary scenario expected to be simulated, the following working condition can be provided: Because the negative-electrode-side battery module is already mounted, the sampling channel line corresponding to the positive-electrode-side battery module may already be set to a relative negative voltage potential. In this case, when the positive-electrode-side battery module is mounted, the chip may bear a very large voltage difference instantaneously. For ease of description, the working condition is referred to as a first simulated working condition for the second exemplary scenario herein.

As can be understood by a person skilled in the art, the positive-electrode-side battery module may be a battery module closest to the positive electrode of the at least two battery modules connected in series, that is, a battery module having the highest battery potential. For example, still referring to the example in FIG. 6, the positive-electrode-side battery module may be the first battery module 611, and the "remaining battery module" may be the second battery module 612. A sampling lead associated with the highest battery potential may be a sampling lead 610-1, and a switch corresponding to the sampling lead may be a switch 620-1. In other words, switches 620-(n+1), ..., and 620-N may be closed before switches 620-1, ..., and 620-n are closed, and after a specified first time delay, the farthest switch 620-1 is closed. The first time delay may be any time delay that can be selected by a person skilled in the art according to needs. For example, a longer first time delay may be selected, so that sampling channel lines 630-1 to 630-n that are not connected to corresponding sampling leads may be set to a relatively low voltage, a shorter first time delay may be selected, so as to improve test efficiency, or a moderate compromise between the former and the latter may be made. Alternatively, the first time delay may be randomly selected.

According to some embodiments, the closing switches corresponding to sampling leads of remaining battery modules of the at least two battery modules may further include: preferentially closing switches corresponding to a pair of sampling leads associated with a maximum battery potential difference among the sampling leads of the remaining battery modules, so as to locally simulate a relatively severe working condition; or randomly closing the switches corresponding to the sampling leads of the remaining battery modules.

According to such an embodiment, for a simulated use scenario, a test can be further performed on a working condition occurring in an application scenario. Particularly, a test working condition corresponds to a configuration mode of the circuit, that is, a common working condition corresponding to a current use scenario of the chip can be simulated, thereby obtaining a realistic and reliable test result.

Specifically, according to the current embodiment, a relatively severe working condition can be simulated for a scenario in which one chip is connected to two or more battery modules, thereby improving reliability of a chip obtained by using such a test method.

According to some embodiments, the performing the closing operation may further include: randomly closing, after the switch corresponding to the sampling lead associated with the highest battery potential is closed, switches corresponding to remaining sampling leads other than the sampling lead associated with the highest battery potential of the positive-electrode-side battery module.

Still referring to the example in FIG. 6, after the farthest switch 620-1 is closed, a 2^{nd} switch (not shown) to an n^{th} switch (620-n) and the like may be closed by using a random policy, so as to perform a power-on test on corresponding sampling channel lines.

According to such an embodiment, for a simulated use scenario, a test can be further performed on a working condition occurring in an application scenario, and a simulation result may be more realistic and comprehensive by using a logic of random closing. Specifically, for the first simulation working condition of the second exemplary scenario, risks to be borne by sampling channel lines other than a sampling channel line that will bear a maximum voltage difference may be further simulated, so that risk test and evaluation can be performed on sampling channel lines and corresponding circuit parts of the chip, to obtain a more reliable test result.

According to some embodiments, in response to the determining that the test circuit is in a second configuration mode, the performing the closing operation may include: closing, if none of switches corresponding to sampling leads of a negative-electrode-side battery module of the at least two battery modules is closed, switches corresponding to sampling leads of remaining battery modules other than the negative-electrode-side battery module of the at least two battery modules; and closing a switch corresponding to a sampling lead associated with a lowest battery potential of the negative-electrode-side battery module after the switches corresponding to the sampling leads of the remaining battery modules are closed for a second time delay.

For the second exemplary scenario, a symmetrical working condition is provided corresponding to the first working condition: Because the positive-electrode-side battery module is already mounted, the sampling channel line corresponding to the negative-electrode-side battery module may already be set to a relative positive voltage potential. In this case, when the negative-electrode-side battery module is mounted, the chip may bear a very large voltage difference instantaneously. For ease of description, the working condition is referred to as a second simulated working condition for the second exemplary scenario herein.

Similarly, as can be understood by a person skilled in the art, the negative-electrode-side battery module may be a battery module closest to the negative electrode of the at least two battery modules connected in series, that is, a battery module having the lowest battery potential. For example, still referring to the example in FIG. 6, the negative-electrode-side battery module may be the second battery module 612, and the "remaining battery module" may be the first battery module 611. In other words, switches 620-1, ..., and 620-n may be closed before switches 620-(n+1), ..., and 620-N are closed, and after a specified second time delay, the farthest switch 620-N is closed. The second time delay may be similar to the first time delay, for example, may be a value the same as or similar to that of the first time delay, or may be selected by following a policy similar to that of the first time delay, and details are not described herein again.

According to some embodiments, the closing switches corresponding to sampling leads of remaining battery modules other than the negative-electrode-side battery module of the at least two battery modules may include: preferentially closing switches corresponding to a pair of sampling leads associated with a maximum battery potential difference among the sampling leads of the remaining battery modules, so as to locally simulate a relatively severe working condition; or randomly closing the switches corresponding to the sampling leads of the remaining battery modules.

According to such an embodiment, for a simulated use scenario, a test can be further performed on a working condition occurring in an application scenario. Particularly, a test working condition corresponds to a configuration mode of the circuit, that is, a common working condition corresponding to a current use scenario of the chip can be simulated, thereby obtaining a realistic and reliable test result.

Specifically, according to the current embodiment, another relatively severe working condition is simulated for a second scenario in which one chip is connected to two or more battery modules.

It may be understood that, for the second scenario, according to some embodiments, the second working condition herein may be combined with the foregoing first working condition (for example, each working condition is tested one or more times), to more comprehensively cover various application scenarios to which the chip may be subjected, so that the test is more standard, comprehensive, and reliable.

According to some embodiments, the performing the closing operation may further include: randomly closing, after the switch corresponding to the sampling lead associated with the lowest battery potential is closed, switches corresponding to remaining sampling leads other than the sampling lead associated with the lowest battery potential of the negative-electrode-side battery module.

Still referring to the example in FIG. 6, for example, after the farthest switch 620-N is closed, a (n+1)^{th} switch to an (N-1)^{th} switch (not shown) and the like may be closed by using a random policy, so as to perform a power-on test on corresponding sampling channel lines.

According to such an embodiment, for a simulated use scenario, a test can be further performed on a working condition occurring in an application scenario, and a simulation result may be more realistic and comprehensive by using a logic of random closing. Specifically, for the second simulation working condition of the second exemplary scenario, risks to be borne by sampling channel lines other than a sampling channel line that will bear a maximum voltage difference may be further simulated, to obtain a more reliable test result.

According to some embodiments, the at least one chip includes a first chip and a second chip, the at least one battery module includes a first battery module, and the determining a configuration mode of a test circuit includes determining that the test circuit is in a third configuration mode, where the third configuration mode indicates that the first chip and the second chip are configured to be connected to corresponding switches of the switch matrix, to enable the first chip and the second chip to be connected to corresponding sampling leads of the first battery module when the corresponding switches are turned on.

According to such an example, a use scenario in which two chips are connected to one battery module can be simulated by using the third configuration mode, and is referred to as a third exemplary scenario herein for ease of description. For example, the quantity of sampling leads of the first battery module may be equal to the sum of the quantity of sampling channel lines of the first chip and the quantity of sampling channel lines of the second chip. Alternatively, the third exemplary scenario may only require that the quantity of sampling leads of the first battery module is the quantity of sampling channel lines of the first chip, and therefore requires that more than one chip samples the first battery module, and does not necessarily require that the quantity of sampling leads of the first battery module is strictly equal to the quantity of sampling channel lines of the first chip and the second chip.

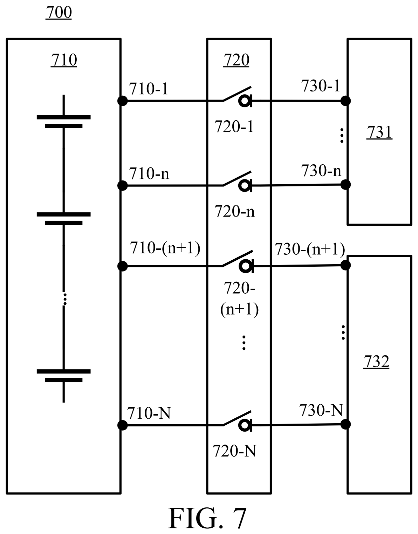

FIG. 7 shows an example of a third configuration mode for the third exemplary scenario. As shown in FIG. 7, in a test circuit 700, a first chip 731 is configured to be connected to corresponding switches 720-1, ..., and 720-n of a switch matrix 720, and a second chip 732 is configured to be connected to corresponding switches 720-(n+1), ..., and 720-N of the switch matrix 720, so that when the corresponding switches 720-1, ..., 720-n, 720-(n+1), ... and 720-N are turned on, sampling channel lines 730-1, ..., and 730-N of the first chip 731 and the second chip 732 can be respectively connected to corresponding sampling leads 710-1, ..., 710-n, 710-(n+1), ..., and 710-N of a battery module 710.

It may be understood that, although FIG. 7 shows the first chip 731 and the second chip 732, the present application is not limited thereto. For example, there may also be a case in which three or more chips sample a same battery module. In addition, although FIG. 7 shows that the sampling channel lines of the first chip 731 and the second chip 732 are in a one-to-one correspondence with the sampling leads of the battery module 710, it may be understood that the present application is not limited thereto. For example, only some sampling leads of the battery module may be sampled. In addition, it may be understood that, the first chip 731 and the second chip 732 may have a same quantity of sampling channel lines, for example, N = 2n, and the first chip 731 and the second chip 732 may alternatively have different quantities of sampling leads. The present application is not limited thereto.

According to such an embodiment, a normalized test based on a use scenario can be implemented. Particularly, a common chip use scenario can be simulated by enabling a configuration mode of a test circuit to be close to a chip use scenario, so that a relatively reliable test result can be obtained.

Specifically, such an embodiment can cover a scenario in which the quantity of sampling channel lines of the first chip is less than the quantity of sampling leads of a single battery module or another scenario in which two or more chips may be used for sampling a single battery, thereby implementing realistic and reliable simulation and test of this common use scenario.

According to some embodiments, a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and in response to the determining that the test circuit is in a third configuration mode, the performing the closing operation may include: closing switches corresponding to the first sampling channel line and the second sampling channel line if none of switches corresponding to remaining sampling channel lines of the first chip and the second chip other than the first sampling channel line and the second sampling channel line is closed; and closing a switch corresponding to the third sampling channel line and a switch corresponding to the fourth sampling channel line after the switches corresponding to the first sampling channel line and the second sampling channel line are closed for a third time delay.

According to such an embodiment, therefore, for the third configuration mode, that is, the third exemplary scenario expected to be simulated, the following working condition can be provided: First, switches corresponding to adjacent sampling channel lines of two chips are closed. For ease of description, the working condition is referred to as a first simulated working condition for the third exemplary scenario herein.

Still referring to FIG. 7, in such an exemplary scenario, a first sampling lead and a second sampling lead of the first battery module that are adjacent to each other are sampling leads 710-n and 710-(n+1); and correspondingly, a first sampling channel line of the first chip is a sampling channel line 730-n, and a second sampling channel line of the second chip is a sampling channel line 730-(n+1). A third sampling lead and a fourth sampling lead that are associated with a maximum battery potential difference are respectively sampling leads 710-1 and 710-N. Therefore, a third sampling channel line of the first chip may be a sampling channel line 730-1, and a fourth sampling channel line of the second chip may be a sampling channel line 730-N.

As shown in FIG. 7, it may be understood that, for the third exemplary scenario, the first simulated working condition assumed herein will be a severest working condition, because in this scenario, two adjacent sampling channel lines 730-n and 730-(n+1) of the two chips are respectively connected to adjacent sampling leads in the battery module through corresponding switches. In this case, the two chips may be approximately regarded as a large chip on the circuit. Therefore, if switches 720-1 and 720-N that correspond to two farthest sampling channel lines 730-1 and 730-N of the chip are turned on, the chip bears a voltage of the entire battery module 710.

In addition, it may be understood that, as already described above, the phrase "closing switches corresponding to the first sampling channel line and the second sampling channel line" used herein may include and is not limited to the following operating logic: simultaneously or nearly simultaneously closing switches 720-n and 720-(n+1) within an allowable error; closing one of the switches 720-n and 720-(n+1) first, and closing the other switch immediately; and closing one of the switches 720-n and 720-(n+1) first, and closing the other switch after a specified time delay or a random time delay, and so on, as long as it is ensured that the two switches corresponding to the first sampling channel line and the second sampling channel line are closed before other switches are closed, so that the two chips can be electrically connected.

Similarly, it may be understood that, the "closing a switch corresponding to the third sampling channel line and a switch corresponding to the fourth sampling channel line" may include and is not limited to the following operating logic: simultaneously or nearly simultaneously closing switches 720-1 and 720-N within an allowable error; closing one of the switches 720-1 and 720-N first, and closing the other switch immediately; and closing one of the switches 720-1 and 720-N first, and closing the other switch after a specified time delay or a random time delay, and so on.

According to such an embodiment, for a simulated use scenario, a test can be further performed on a working condition occurring in an application scenario. Particularly, a test working condition corresponds to a configuration mode of the circuit, that is, a common working condition corresponding to a current use scenario of the chip can be simulated, thereby obtaining a realistic and reliable test result.

Specifically, according to the current embodiment, a test effect and reliability of a chip obtained through a test can be improved by simulating a severe scenario, and a chip obtained after such a test still has satisfactory reliability even when dealing with an extreme working condition.

According to some embodiments, the performing the closing operation may further include: randomly closing switches corresponding to remaining sampling channel lines of the first chip and the second chip other than the first sampling channel line, the second sampling channel line, the third sampling channel line, and the fourth sampling channel line after the switch corresponding to the third sampling channel line and the switch corresponding to the fourth sampling channel line are closed.

Still referring to the example in FIG. 7, for example, after adjacent switches 720-n and 720-(n+1) are closed first, and then farthest switches 720-1 and 720-N are closed, remaining switches (not shown) are closed by using a random policy, so as to perform a power-on test on corresponding sampling channel lines.

According to such an embodiment, for a simulated use scenario, a test can be further performed on a working condition occurring in an application scenario; and a simulation result may be more realistic and comprehensive by using a logic of random closing. In other words, for the first simulation working condition of the third exemplary scenario, risks to be borne by sampling channel lines other than a sampling channel line that will bear a maximum voltage difference may be further simulated, to fully test the tolerance of the chip.

According to some embodiments, in response to the determining that the test circuit is in a third configuration mode, the performing the closing operation may include: randomly closing switches corresponding to sampling channel lines of the first chip and the second chip.

Still referring to FIG. 7, and for ease of description, the working condition is referred to as a second simulation working condition for the third exemplary scenario. For the second simulation working condition of the third exemplary scenario, any two or more of the switches 720-1, ..., 720-n, 720-(n+1), ..., and 720-N may be closed, and such closing may follow a random sequence, and/or there may be a random time delay between two switches that are closed sequentially.

Therefore, for the third exemplary scenario, in addition to the provided severest working condition, other working conditions that are more common in practice may be further simulated in a test. According to such an embodiment, other common plugging working conditions can be covered. In addition, a simulation result may be more realistic by using a logic of random closing, and therefore a reliable and comprehensive test result is obtained.

According to some embodiments, a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and the third configuration mode may further indicate that the first sampling channel line is electrically connected to the second sampling channel line.

According to such an example, in the foregoing third exemplary scenario, the two chips are further short-circuited. For ease of description, the scenario herein may be referred to as a fourth exemplary scenario. The fourth exemplary scenario may be used to cover actual application. When a quantity of sampling channel lines of a single chip is less than a quantity of sampling leads of a single to-be-sampled battery, two or more chips may be short-circuited or connected in series in advance.

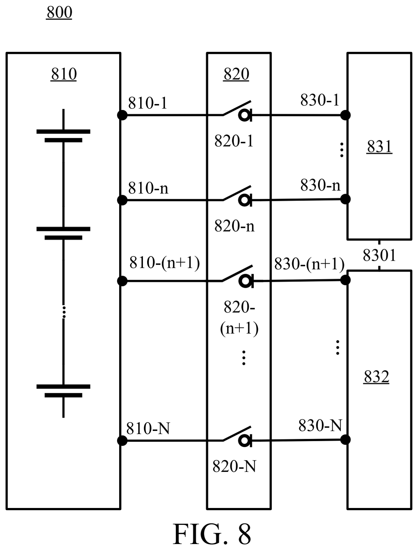

Refer to FIG. 8 as an example. Similar to FIG. 7, in a test circuit 800 in FIG. 8, a first chip 831 is configured to be connected to corresponding switches 820-1, ..., and 820-n of a switch matrix 820, and a second chip 832 is configured to be connected to corresponding switches 820-(n+1), ..., and 820-N of the switch matrix 820, so that when the corresponding switches 820-1, ..., 820-n, 820-(n+1), ... and 820-N are turned on, sampling channel lines 830-1, ..., and 830-N of the first chip 831 and the second chip 832 can be respectively connected to corresponding sampling leads 810-1, ..., 810-n, 810-(n+1), ..., and 810-N of a battery module 810. Similarly, it may be understood that, the quantity of channels, the quantity of chips, and the like in the figure are merely examples, and the present application is not limited thereto.

As shown in FIG. 8, the first chip 831 and the second chip 832 are electrically connected by using a short-circuiting line 8301.

According to such an embodiment, a normalized test based on a use scenario can be implemented. Particularly, a common chip use scenario can be simulated by enabling a configuration mode of a test circuit to be close to a chip use scenario, so that a relatively reliable test result can be obtained.

Specifically, in such an embodiment, based on the third scenario, a fourth exemplary scenario in which the chip is short-circuited in advance is further considered, so that scenarios that the chip may face can be covered more comprehensively, thereby obtaining a reliable test result.

According to some embodiments, in response to the determining that the test circuit is in a third configuration mode, the performing the closing operation may include: closing switches corresponding to sampling channel lines of the second chip if none of switches corresponding to sampling channel lines of the first chip is closed; and closing a switch corresponding to the third sampling channel line after the switches corresponding to the sampling channel lines of the second chip are closed for a third time delay.

Still referring to FIG. 8 as an example, in such an exemplary scenario, a first sampling lead and a second sampling lead of the first battery module that are adjacent to each other are sampling leads 810-n and 810-(n+1); and correspondingly, a first sampling channel line of the first chip is a sampling channel line 830-n, and a second sampling channel line of the second chip is a sampling channel line 830-(n+1). A third sampling lead and a fourth sampling lead that are associated with a maximum battery potential difference are respectively sampling leads 810-1 and 810-N. Therefore, a third sampling channel line of the first chip may be a sampling channel line 830-1, and a fourth sampling channel line of the second chip may be a sampling channel line 830-N. In other words, the switches 820-(n+1) to 820-N may be closed first, and after the third time delay, the switch 820-1 is closed. For ease of description, such a working condition may be referred to as a first working condition for the fourth exemplary scenario.

According to some embodiments, in response to the determining that the test circuit is in a third configuration mode, the performing the closing operation may include: closing switches corresponding to sampling channel lines of the first chip if none of switches corresponding to sampling channel lines of the second chip is closed; and closing a switch corresponding to the fourth sampling channel line after the switches corresponding to the sampling channel lines of the first chip are closed for a fourth time delay. It may be understood that, the working condition herein is relatively symmetrical to the foregoing first working condition, and for ease of distinction, may be referred to as a second working condition.

It may be understood that, the third time delay and or the fourth time delay may be similar to the first time delay and the second time delay, for example, may be a value the same as or similar to that of the first time delay or the second time delay, or may be selected by following a policy similar to that of the first time delay or the second time delay, and details are not described herein again.

According to such an embodiment, for a simulated use scenario, a test can be further performed on a working condition occurring in an application scenario. Particularly, a test working condition corresponds to a configuration mode of the circuit, that is, a common working condition corresponding to a current use scenario of the chip can be simulated, thereby obtaining a realistic and reliable test result.

Specifically, according to the current embodiment, by closing one of the chips first, and then closing a farthest switch in the other chip after a time delay, a severe working condition that can be withstood during hot-swapping when the chip is short-circuited can be simulated, so as to obtain a reliable test result.

According to some embodiments, the performing the closing operation may further include: randomly closing switches corresponding to remaining sampling channel lines of the first chip other than the third sampling channel line after the switch corresponding to the third sampling channel line is closed.

Still referring to FIG. 8 as an example, for the first working condition of the fourth exemplary scenario, after the switch 820-1 is closed, a switch (for example, 820-n) corresponding to a remaining sampling channel line (for example, 830-n) of the first chip 831 may be randomly closed.

It may be understood that, for the foregoing symmetrical working condition, that is, for the second working condition of the fourth exemplary scenario, there may be a subsequent random operation similarly. For example, after the switches corresponding to the sampling channel lines of the first chip are closed for a fourth time delay, and after a switch corresponding to the fourth sampling channel line is closed, switches corresponding to remaining sampling channel lines of the second chip may be randomly closed.

According to such an embodiment, for a simulated use scenario, a test can be further performed on a working condition occurring in an application scenario, and a simulation result may be more realistic and comprehensive by using a logic of random closing. Specifically, for the fourth exemplary scenario, other common plugging working conditions and sampling channel lines can be covered, so that risk test and evaluation can be performed on sampling channel lines and corresponding circuit parts of the chip, to obtain a more reliable test result.

According to some embodiments, the operation termination condition may include at least one of the following: a quantity of execution times of a closing operation for the at least one chip reaches a first threshold, or a quantity of execution times of a closing operation based on a particular configuration mode reaches a second threshold for the particular configuration mode.

According to such an embodiment, after the quantity of test times is satisfied, it can be determined that the operation termination condition is satisfied, so as to test performance of the chip, for example, a five-point test. It may be understood that, the first threshold and the second threshold may alternatively be 1, that is, a scenario in which testing is performed only once may also be covered.

According to some embodiments, the operation termination condition may also include that for a particular configuration mode, a closing operation in one or more particular working conditions has been implemented. As a specific non-limiting example, the operation termination condition may include that, for the first configuration mode (the first exemplary scenario), a first predetermined quantity of closing operations are already implemented for the first working condition, a second predetermined quantity of closing operations are already implemented for the second working condition, and so on. As a more specific non-limiting example, it may be specified that a quantity of hot-plugging times in each working condition is not less than 30. However, it may be understood that the present application is not limited thereto.

Therefore, chip testing can be further normalized by defining a termination condition.

Specifically, when the first threshold or the second threshold in the operation termination condition is set to be greater than 1, the credibility can be further tested by adding a plurality of repeated tests of a same working condition. For another example, if the same first threshold or second threshold is stipulated at different chip manufacturers or test sites, chip testing can be further normalized and standardized, and differences in test results are reduced. In addition, a chip obtained in this way is more stable and normalized.

According to some embodiments, the test method may further include, in response to determining that an operation termination condition is not satisfied: performing a power-off operation on the at least one chip; discharging a capacitor in the at least one chip; and repeatedly performing the steps of performing a closing operation used for closing at least two switches in the switch matrix and testing functions of the at least one chip, where the operation termination condition includes at least one of the following: a quantity of execution times of a closing operation for the at least one chip reaches a first threshold, or a quantity of execution times for each working condition of the at least one working condition reaches a second threshold for the working condition.

According to such an embodiment, when a termination condition is not satisfied (for example, a quantity of times is not enough or a test is not performed for a particular configuration mode), a switch is opened, a configuration mode is determined, and repeated execution is performed, so that a test solution is further normalized and automated, and a manual plug-in process can be avoided, thereby improving test efficiency.

According to such an embodiment, after the quantity of test times is satisfied, it can be determined that the operation termination condition is satisfied, so as to test functions of the chip, for example, but not limited to, various sample function tests described below. It may be understood that, the first threshold and the second threshold may alternatively be 1, that is, a scenario in which testing is performed only once may also be covered.

According to some embodiments, the operation termination condition may also include that for a particular configuration mode, a closing operation in one or more particular working conditions has been implemented. As a specific non-limiting example, the operation termination condition may include that, for the first configuration mode (the first exemplary scenario), a first predetermined quantity of closing operations are already implemented for the first working condition, a second predetermined quantity of closing operations are already implemented for the second working condition, and so on. As a more specific non-limiting example, it may be specified that a quantity of hot-plugging times in each working condition is not less than 30. However, it may be understood that the present application is not limited thereto.

Therefore, chip testing can be further normalized by defining a termination condition.

Specifically, when the first threshold or the second threshold in the operation termination condition is set to be greater than 1, the credibility can be further tested by adding a plurality of repeated tests of a same working condition. For another example, if the same first threshold or second threshold is stipulated at different chip manufacturers or test sites, chip testing can be further normalized and standardized, and differences in test results are reduced. In addition, a chip obtained in this way is more stable and normalized.

In addition, according to such an embodiment, a discharging operation is performed before a closing operation is repeatedly performed each time, so as to ensure that the repeatedly performed operations are all performed in a condition in which the capacitor is not charged, thereby reducing impact of capacitor charging in a previous operation, so that a test working condition is worse. Therefore, a function of a chip obtained in a test is more guaranteed. Specifically, if there is no discharging unit, after the first time of hot-plugging (closing operation), the AFE chip has been locally charged, and subsequent hot-plugging has increasingly weak stress. On the contrary, a discharging unit is added by design, so that each time of hot-plugging is closer to a realistic situation, thereby obtaining a more realistic test effect, and better facilitating repeated tests to improve reliability.

It may be understood that, the discharging operation may be implemented through grounding, or may be implemented through another operation that can be understood by a person skilled in the art. For example, a discharging process may be considered to be completed after a discharging loop is turned on for specified duration. Such duration may be determined by a person skilled in the art according to experience, experiments, or other methods, may be fixed in a hot-plugging test, or may be modified according to other environmental conditions, circuit conditions, or sample conditions. The discharging operation may alternatively be a discharging operation for a test bench.

According to one or more embodiments of the present application, various possible hot-plugging scenarios and working conditions in actual application can be simulated, and applicable scenarios are wide and have equivalent normativity and consistency.

According to some embodiments, the test method may further include: regulating, in response to that the step of determining that the at least one chip is powered on is performed for the at least one chip for the first time, a cell voltage of a battery in the at least one battery module to a specified value before the testing functions of the at least one chip.

According to such an embodiment, stability of the test can be ensured. As a non-limiting example, the specified value of the cell voltage may be 4.25 V. For example, the specified value of the cell voltage may be substantially equal to a cell voltage to be used in a corresponding scenario or working condition, or may be higher than a cell voltage to be used in a corresponding scenario or working condition, so as to obtain a more guaranteed test result. Other examples are described in detail below with reference to specific embodiments.

According to some embodiments, the testing performance of the at least one chip includes performing a supply voltage range test on the at least one chip.

The supply voltage range test may be a five-point test, that is, the chip is tested for five times under five predetermined combination conditions such as an ambient temperature and a voltage. The supply voltage range test may alternatively be another test, detection, check, or verification that can be understood by a person skilled in the art and that is performed on the voltage performance of the chip.

Additionally or alternatively, the testing functions of the at least one chip may further include performing at least one of the following on the at least one chip: a supply current range test, a cell voltage sampling precision test, a cell temperature sampling precision test, and a leakage current diagnosis threshold test. Similarly, it may be understood that, these tests may be tests, detections, checks, or verifications that can be understood by a person skilled in the art and that is performed on the corresponding performance of the chip.

Some non-limiting examples of chip testing are provided below, and details are not described herein again.

According to such an embodiment, performance of the chip can be ensured, so that a test effect is more reliable.

According to one or more aspects of the present application, a test apparatus for a chip is further disclosed, including: a switch matrix; and a control device, where the control device is configured to control an operation on at least one switch in the switch matrix, to perform a power-on operation on at least one chip according to a configuration mode; and the control device is configured to connect the at least one chip to the at least one battery module based on at least one working condition corresponding to the configuration mode.

According to some exemplary embodiments, the test apparatus may further include at least one battery module, where the performing a power-on operation on at least one chip according to a configuration mode includes connecting the at least one chip to the at least one battery module.

According to some exemplary embodiments, the connecting the at least one chip to the at least one battery module includes: performing a closing operation used for closing at least two switches in the switch matrix.

According to some exemplary embodiments, the performing a closing operation used for closing at least two switches in the switch matrix includes closing a switch in the switch matrix based on at least one of the following policies: a first policy, where the first policy is used for preferentially closing two switches of a power-on loop that form a maximum potential difference; or a second policy, where the second policy is used for preferentially closing a switch that is configured to form a path between the at least one battery module.

According to some exemplary embodiments, the test apparatus includes an interface configured to connect to the at least one chip, for example, an interface connected to a to-be-tested chip such as an AFE or a CSC.

According to some exemplary embodiments, the control device includes an upper computer.

According to one or more aspects of the present application, a test apparatus for a chip is further disclosed, including: at least one battery module; a switch matrix; and an upper computer, where the upper computer is configured to control an operation on at least one switch in a switch matrix, the switch matrix is configured to connect at least one chip to at least one battery module, and the upper computer is configured to perform the method according to one or more embodiments of the present application.

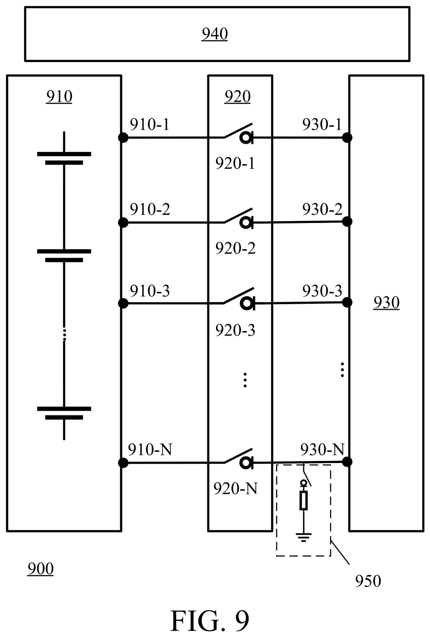

Referring to FIG. 9, a test apparatus 900 may include at least one battery module 910, a switch matrix 920, and an upper computer 940. At least one chip 930 may be configured to be connected to corresponding switches 920-1, 920-2, 920-3, ..., and 920-N of the switch matrix 920, so that when the corresponding switches 920-1, 920-2, 920-3, ..., and 920-N are turned on, sampling channel lines 930-1, 930-2, 930-3, ..., and 930-N of the at least one chip 930 can be respectively connected to corresponding sampling leads 910-1, 910-2, 910-3, ..., and 910-N of the at least one battery module 910.

As can be understood by a person skilled in the art, that the upper computer is capable of controlling an operation of at least one switch in the switch matrix may mean that the upper computer is capable of being in electrical connection, signal connection, or operable connection in another manner to the switch matrix, to control opening or closing of the one or more switches in the switch matrix.

According to some embodiments, the test apparatus may further include at least one discharging unit, where the at least one discharging unit is configured to discharge a corresponding capacitor in the at least one chip when the at least one discharging unit is switched on.

For example, referring to FIG. 9, the test apparatus 900 may further include a discharging unit 950. Specifically, the discharging unit 950 may include a grounding switch and a resistor. Alternatively, the discharging unit may be disposed by using another circuit capable of discharging the capacitor, and the present application is not limited thereto.

According to such an embodiment, by disposing the grounding switch, a discharging operation can be performed on the chip. Therefore, the closing operation may be performed when the capacitor is discharged, thereby reducing impact of possible capacitor charging in the chip, and implementing a more reliable test.

According to one or more aspects of the present application, an upper computer is further disclosed, where the upper computer is configured to control an operation on at least one switch in a switch matrix, the switch matrix is configured to connect at least one chip to at least one battery module, and the upper computer is configured to perform the method according to one or more embodiments of the present application.

According to one or more aspects of the present application, a chip for a battery is further disclosed, where the chip is tested by using the method according to one or more embodiments of the present application.

According to one or more aspects of the present application, an electronic device is further disclosed, including: at least one processor; and a memory communicatively connected to the at least one processor, where the memory stores an instruction executable by the at least one processor, and the instruction is executed by the at least one processor, to enable the at least one processor to perform the method according to one or more embodiments of the present application.

According to one or more aspects of the present application, a non-transitory computer-readable storage medium storing a computer instruction is further disclosed, where the computer instruction is used for causing the computer to perform the method according to one or more embodiments of the present application.

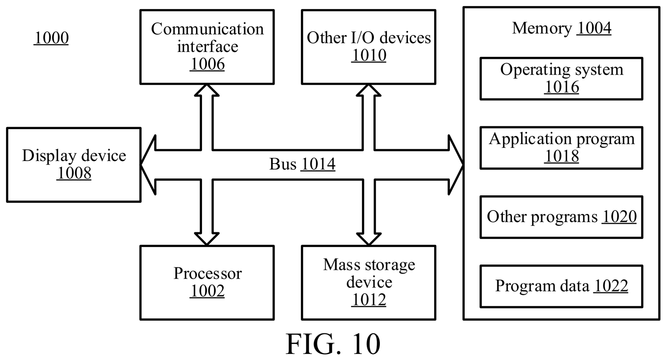

Descriptive examples of a computer device, a non-transitory computer-readable storage medium, and a computer program product according to the present application are described below with reference to FIG. 10.

FIG. 10 shows an example configuration of the computer device 1000 that may be used to implement the method described in this specification. The computer device 1000 may be various different types of devices, for example, a server of a service provider, a device associated with a client (for example, a client device), a system-on-chip, and/or any other suitable computer device or computing system. Examples of the computer device 1000 include, but are not limited to: desktop computers, server computers, laptop or netbook computers, mobile devices (such as tablets, cellular or other wireless phones (such as smart phones), notebook computers, or mobile stations), wearable devices (such as glasses or watches), or other display devices, car computers, and so on. Therefore, the computer device 1000 may range from a full resource device (such as a personal computer) having a large quantity of memory and processor resources to a low resource device having limited memory and/or processing resources.

The computer device 1000 may include at least one processor 1002, a memory 1004, (multiple) communication interfaces 1006, a display device 1008, another input/output (I/O) device 1010, and one or more mass storage devices 1012 that can communicate with each other, for example, by using a system bus 1014 or another suitable connection.

The processor 1002 may be a single processing unit or multiple processing units, each of which may include a single or multiple computing units or multiple cores. The processor 1002 may be implemented as one or more microprocessors, microcomputers, microcontrollers, digital signal processors, central processing units, state machines, logic circuits, and/or any devices that manipulate signals based on operating instructions. In addition to other capabilities, the processor 1002 may be configured to acquire and execute computer-readable instructions stored in the memory 1004, the mass storage device 1012, or any other computer-readable medium, such as program codes of an operating system 1016, program codes of an application program 1018, program codes of other programs 1020, etc.

The memory 1004 and the mass storage device 1012 are examples of the computer-readable storage medium for storing instructions. The instructions are executed by the processor 1002 to implement various functions described above. For example, the memory 1004 may generally include a volatile memory or a non-volatile memory (such as RAM or ROM). In addition, the mass storage device 1012 may generally include hard drives, solid-state drives or removable media, including external and removable drives, memory cards, flash memories, floppy disks, optical disks (such as CDs or DVDs), storage arrays, network attached storage, storage area networks, etc. The memory 1004 and the mass storage device 1012 may be collectively referred to as a memory or computer-readable storage medium in this specification, and may be a non-transient medium capable of storing computer-readable and processor-executable program instructions as computer program codes. The computer program codes may be executed by the processor 1002 as a specific machine configured to implement the operations and functions described in the examples in this specification.

Multiple program modules may be stored in the mass storage device 1012. These programs include an operating system 1016, one or more application programs 1018, other programs 1020, and program data 1022, and they may be loaded into the memory 1004 for execution. Examples of such application programs or program modules may include computer program logics (such as computer program codes or instructions) used for implementing the method according to one or more embodiments of the present application.

Although shown in FIG. 10 as being stored in the memory 1004 of the computer device 1000, the modules 1016, 1018, 1020, and 1022 or a part thereof may be implemented by using any form of the computer-readable medium that can be accessed by the computer device 1000. As used in this specification, the "computer-readable medium" includes at least two types of computer-readable media, that is, a computer storage medium and a communication medium.

The computer storage medium includes volatile and non-volatile, removable and non-removable media implemented by any method or technology for storing information, such as computer-readable instructions, data structures, program modules, or other data. The computer storage medium includes, but not limited to, RAM, ROM, EEPROM, flash memory or other storage technologies, CD-ROM, digital versatile disc (DVD), or other optical storage apparatuses, magnetic boxes, magnetic tapes, magnetic disk storage apparatuses, or other magnetic storage devices, or any other non-transmission medium that may be used for storing information for access by the computer device.

In contrast, the communication medium may specifically implement a computer-readable instruction, a data structure, a program module, or other data in a modulated data signal such as a carrier or another transport mechanism. The computer storage medium defined in this specification does not include a communication medium.

The computer device 1000 may further include one or more communication interfaces 1006, configured to exchange data with another device, for example, through a network or a direct connection, as discussed above. Such communication interface may be one or more of the following: any type of network interface (such as Network Interface Card (NIC)), wired or wireless (such as IEEE 802.10 Wireless LAN (WLAN)) wireless interface, Worldwide Interoperability for Microwave Access (Wi-MAX) interface, Ethernet interface, Universal Serial Bus (USB) interface, cellular network interface, Bluetooth^{™} interface, Near Field Communication (NFC) interface, etc. The communication interface 1006 may facilitate communication across various types of networks and protocols, including wired networks (such as LAN and cable) and wireless networks (such as WLAN, cellular network, or satellite), the Internet, etc. The communication interface 1006 may further provide communication with external storage apparatuses (not shown) such as storage arrays, network attached storage, storage area networks, etc.

In some examples, a display device 1008 such as a monitor may be included for displaying information and images to users. Other I/O devices 1010 may be devices that receive various inputs from users and provide various outputs to users, and may include touch input devices, gesture input devices, cameras, keyboards, remote controls, mice, printers, audio input/output devices, etc.

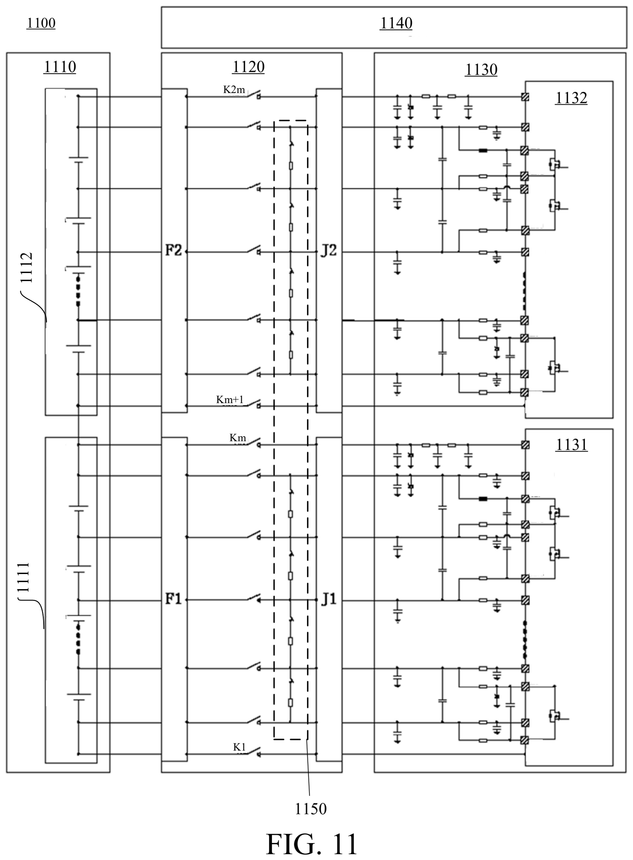

Specific non-limiting examples according to the present application are described below with reference to FIG. 11 to FIG. 14.

As shown in FIG. 11, an exemplary test circuit 1100 may include at least one battery module 1110, a switch matrix 1120, at least one chip 1130, and an upper computer 1140.

According to a specific example of FIG. 11, two analog front-end (AFE) chips 1131 and 1132 are shown. The two AFE chips may be designed by using a typical recommendation circuit to form a cell monitor circuit (CMC) or a cell monitor unit (CMU). In some embodiments, the CMC needs to have at least two AFE chips.

The at least one battery module 1110 may include battery modules 1111 and 1112. The quantity of cells of a battery module may vary in an actual application process. A realistic cell or a cell simulator may be used.

The switch matrix 1120 may include a switch for turning on and turning off a module and a discharging circuit for discharging the CMC. For an on-off switch, closing of the switch may be equivalent to connecting of a connector, and opening of the switch is equivalent to unplugging of the connector. Closing and opening of a switch (a relay, a semiconductor switch, or the like) can be used to simulate switch-on and switch-off of connector plugging in an actual application process, which is more flexible. In addition, after the switch matrix cooperates with the upper computer, each plugging sequence can be flexibly simulated.

The upper computer 1140 may be configured to control a switching logic and a closing sequence of the switch matrix, to simulate hot-plugging working conditions of different connecting sequences. In addition, the upper computer 1140 may be configured to receive and read information of the CMC, and determine whether a circuit function of the CMC after hot-plugging is normal. The upper computer 1140 may be configured to perform the method according to one or more embodiments of the present application. It may be understood that, the present application is not limited thereto, and the method according to one or more embodiments of the present application may be implemented by using another device, apparatus, unit, code logic, or the like.

Still refer to FIG. 11, which shows a test circuit configuration example for the first exemplary scenario. As a specific non-limiting example, the quantity of cells of the first battery 1111 is the same as the quantity of sampling channels of the first chip 1131, all sampling leads of the first battery 1111 are concentrated on a connector F1, and all sampling channel lines of the first chip 1131 are concentrated on J1. As a more specific non-limiting example, both the quantity of cells of the first battery 1111 and the quantity of sampling channels of the first chip 1131 may be 16.

For such a circuit configuration, as an example of the first working condition for the first exemplary scenario described in this specification, for the first chip 1131, a severest working condition may be that switches K1 and Km at two ends are first closed.

According to some embodiments, FIG. 11 further shows a second chip 1132, whose configuration may be the same as that of the first chip 1131. It may be understood that, although it is shown that the two chips 1131 and 1132 are respectively configured to be connected to the two corresponding batteries 1111 and 1112, the present application is not limited thereto. For example, the test circuit may include only one chip and one battery module. Alternatively, the test circuit may include more chips and more battery modules. In such an example, for the second chip 1132, an example of the first working condition for the first exemplary scenario, that is, a severest working condition is that two switches Km+1 and K2m at two ends are closed first.

For example, the upper computer 1140 (or another possible unit, apparatus, or the like) may be configured to independently or simultaneously perform a closing operation on the first chip and the second chip to close switches on two sides. Alternatively, the upper computer 1140 may be configured to separately perform a closing operation on the first chip and the second chip, to test two or more chips in sequence, and so on, and the present application is not limited thereto.

For the first chip 1131, after the switches K1 and Km at two ends are first closed, other pins may be closed in a random order and/or with a random time delay. According to some embodiments and similarly, for the second chip 1132, other pins may be closed in a random order and/or with a random time delay after the switches Km+1 and K2m at two ends are first closed.

As another example, as a second working condition for the first exemplary scenario, to simulate a situation closest to reality, switches K1 to Km and switches Km+1 to K2m may be randomly closed, including, for example, with a random time delay and in a random closing sequence.

According to one or more embodiments of the present application, a discharging unit 1150 may be configured according to some embodiments. For example, after power-off is simulated for each time of hot-plugging, all discharging switches in the discharging unit 1150 may be closed to discharge the circuit, to restore an initial state, thereby ensuring consistency of the initial state of each time of hot-plugging.

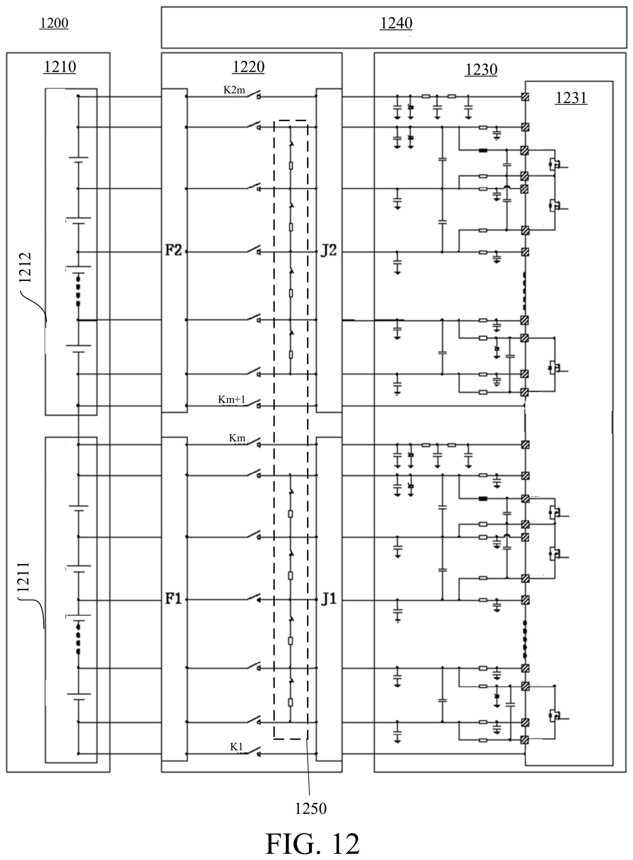

A test circuit configuration example for the second exemplary scenario is described below with reference to FIG. 12. As shown in FIG. 12, a test circuit 1200 may include at least one battery module 1210, a switch matrix 1220, at least one chip 1230, and an upper computer 1240. More specifically, the at least one battery module 1210 includes battery modules 1211 and 1212, and the at least one chip includes an AFE chip 1231, where a sum of quantities of cells of the battery modules 1211 and 1212 is the same as the quantity of sampling channels of the AFE chip 1231. The battery module 1211 and the battery module 1212 have independent sampling leads F1 and F2, and all sampling channel lines of the AFE chip 1231 are concentrated on J1. More specifically, the quantity M1 of cells of the battery module 1211 may be equal to 8, the quantity M2 of cells of the battery module 1212 may be equal to 8, M1+M2 = 16, and the quantity of sampling channels of the AFE chip 1231 may be equal to 16. According to some embodiments, the at least one chip may further include a second AFE chip, whose configuration may be the same as that of the first AFE chip (not shown).

As a first simulation working condition for the second exemplary scenario, switches K1 to Km of the AFE chip 1231 may be closed first, and then Km+1 to K2m are closed after a specified time delay. In a process of closing the switches Km+1 to K2m, K2m may be preferentially closed, and then Km+1 to K2m-1 are randomly closed.

As a second simulation working condition for the second exemplary scenario, switches Km+1 to K2m of the AFE chip 1231 may be closed first, and then K1 to Km are closed after a specified time delay. In a process of closing the switches K1 to Km, K1 may be preferentially closed, and then K2 to Km are randomly closed.

According to one or more embodiments of the present application, a discharging unit 1250 may be configured according to some embodiments. For example, after power-off is simulated for each time of hot-plugging, all discharging switches in the discharging unit 1250 may be closed to discharge the circuit, to restore an initial state, thereby ensuring consistency of the initial state of each time of hot-plugging.

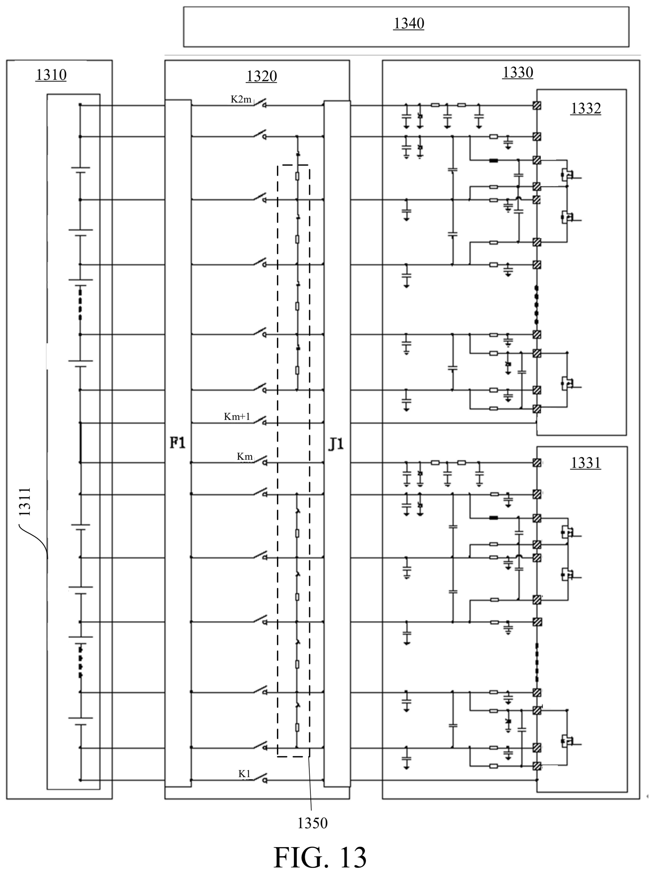

A test circuit configuration example for the third exemplary scenario is described below with reference to FIG. 13. As shown in FIG. 13, a test circuit 1300 may include at least one battery module 1310, a switch matrix 1320, at least one chip 1330, and an upper computer 1340. More specifically, the at least one battery module 1310 includes a battery module 1311, and the at least one chip includes an AFE chip 1331 and an AFE chip 1332, where the quantity of cells of the battery module 1311 is the same as a sum of the quantities of sampling channels of the AFE chip 1331 and the AFE chip 1332.

The battery module 1311 may be a single connector F1 that is led out. Alternatively, the battery module 1311 may be divided into two connectors F1 and F2 (not shown). All sampling channel lines of the AFE chip 1331 and the AFE chip 1332 are concentrated on J1. As a more specific example, the quantity M1 of cells of the battery module 1311 is equal to 32, and the quantity of sampling channels of the AFE chip 1331 and the quantity of sampling channels of the AFE chip 1332 are both 16 +16.

As a first simulation working condition for the third exemplary scenario, switches Km and Km+1 may be preferentially closed, K1 and K2m are closed after a time delay, and remaining other switches are randomly closed.

As a second simulation working condition for the third exemplary scenario, the switches K1 to K2m may be all closed with a random time delay.

According to one or more embodiments of the present application, for example, a discharging unit 1350 may be configured. For example, after power-off is simulated for each time of hot-plugging, all discharging switches in the discharging unit 1350 may be closed to discharge the circuit, to restore an initial state, thereby ensuring consistency of the initial state of each time of hot-plugging.

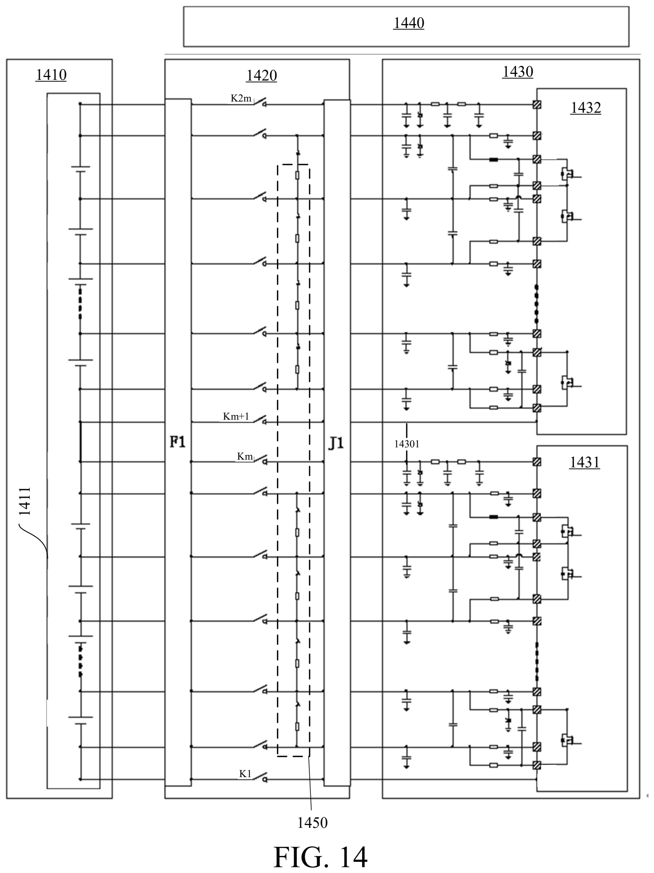

A test circuit configuration example for the fourth exemplary scenario is described below with reference to FIG. 14. The fourth exemplary scenario may be a scenario in which a short node exists between two AFE chips based on the third exemplary scenario.

As shown in FIG. 14, a test circuit 1400 may include at least one battery module 1410, a switch matrix 1420, at least one chip 1430, and an upper computer 1440. More specifically, the at least one battery module 1410 includes a battery module 1411, and the at least one chip includes an AFE chip 1431 and an AFE chip 1432, where the quantity of cells of the battery module 1411 is the same as a sum of the quantities of sampling channels of the AFE chip 1431 and the AFE chip 1432. The AFE chip 1431 and the AFE chip 1432 may be short-circuited by using a short-circuiting line 14301.

The battery module 1411 may be a single connector F1 that is led out. Alternatively, the battery module 1411 may be divided into two connectors F1 and F2 (not shown). All sampling channel lines of the AFE chip 1431 and the AFE chip 1432 are concentrated on J1. As a more specific example, the quantity M1 of cells of the battery module 1411 is equal to 32, and the quantity of sampling channels of the AFE chip 1431 and the quantity of sampling channels of the AFE chip 1432 are both 16 +16.

It may be understood that, in such an example, the switches Km and Km+1 may respectively correspond to the first sampling lead and the second sampling lead described above, and the switches K1 and K2m may correspond to the third sampling channel line and the fourth sampling channel line.

As a first simulation working condition for the fourth exemplary scenario, the switches Km+1 to K2m may be preferentially closed, then the switch K1 is closed with a time delay, and finally the switches K2 to Km are randomly closed.

As a second simulation working condition for the fourth exemplary scenario, the switches K1 to Km may be preferentially closed, then the switch K2m is closed with a time delay, and finally the switches Km+1 to K2m-1 are randomly closed.

According to one or more embodiments of the present application, for example, a discharging unit 1450 may be configured. For example, after power-off is simulated for each time of hot-plugging, all discharging switches in the discharging unit 1450 may be closed to discharge the circuit, to restore an initial state, thereby ensuring consistency of the initial state of each time of hot-plugging.

According to one or more embodiments of the present application, there may be the following exemplary prescription for a sample state:
- sample quantity: 6, derived from three different batches;
- sample string quantity configuration: sampling channels of a chip need to be fully configured.
- quantity of hot-plugging times in each working condition: not less than 30;
- cell voltage value: not less than 4.25 V;
- sample state: there is no abnormality after five-point function verification.

As a specific non-limiting example, in a test, the following steps may be included:
a) Build a simulated test bench for a test sample according to a hot-plugging test bench requirement.
b) Power on the test sample, adjust a cell voltage to a specified value, and check whether a function of the test sample satisfies a specified requirement.
c) Power off the test sample, and discharge residual charges of the sample.
d) Simulate a hot-plugging scenario and a corresponding working condition, sequentially connecting corresponding cell channels, and check, after all channels are connected, whether the function of the sample is normal.
e) Repeat the processes c to d, to complete a requirement for a quantity of test times of hot-plugging in the working condition.
f) Repeat the processes c to e, to complete test requirements in remaining hot-plugging working conditions.
g) Further repeat, for example, the processes b to f, to complete test requirements in remaining sample hot-plugging working conditions.

It may be understood that, the foregoing "scenario" and "working condition" may correspond to various "exemplary scenarios" and "simulated working conditions" described in the present application.

The following are exemplary test sample parameters:
- sample quantity that is 6 or may be another sample quantity;
- sample configuration string quantity that is S and may be a string quantity selected according to a specific hot-plugging test bench requirement, a typical circuit configuration, a battery module, a quantity of cells of each battery module, a CMU configuration requirement, and the like;
- sample state: after a test, a function state meets a required level requirement;
- cell voltage value that is, for example, 4.25 V and may be determined by negotiation between a manufacturer and an application party, where as an example, when a cell voltage value has a deviation, difference content may be required to be described in a test report; and
- quantity of hot-plugging times: not less than 30.

It may be understood that, throughout this specification, unless otherwise specified or otherwise clearly indicated in the context, a term such as a test sample, a chip, a device under test, a test sample, or a test chip may be interchangeably used to indicate a chip on which a hot-plugging test is to be performed, is being performed, or has been performed; and a term such as experiment, test, verification, and function check may be interchangeably used to indicate verifying performance of a chip or a test sample or checking a function of the chip or the test sample, and the present disclosure is not limited thereto.

For example, examples of the following environmental conditions and supply voltages are provided.

Exemplary environmental conditions may include:
- room temperature: 23°C±5°C;
- relative humidity: 20%RH to 80%RH;
- barometric pressure: 86 kPa to 106 kPa; and
- altitude: not more than 1000 m. as an example, if the altitude exceeds 1000 m, the result is corrected, and for example, the result is corrected according to related regulations of GB/T 18488.1-2015.

Exemplary supply voltage conditions may include:
- cell voltage: 3.65 V; and
- total supply voltage: (3.65*L) V

where L is the quantity of cells of the battery module, and for example, may be 8, 12, 16, or 18, and may be changed according to a specific hot-plugging test bench requirement, a typical circuit configuration, a battery module, a quantity of cells of each battery module, a CMU configuration requirement, and the like.

The following are specific non-limiting examples of some exemplary functional parameter test methods.

For example, the supply voltage range test may include verifying the supply voltage range of the AFE chip by using the following test method.
a) Place a test sample in a climatic test chamber, and then adjust a temperature of the climatic test chamber to a specified temperature value.
b) Power on the test sample, adjust a cell voltage to a specified value, and check whether a function of the test sample satisfies a specified requirement.
c) Remain, after the temperature of the test sample is stable, in the condition for a specified running time.
d) During running, monitor, in realistic time, whether a working state of the test sample meets a specified requirement.
   - sample quantity: 6
   - running time: 24 h
   - A combination of an ambient temperature and a supply voltage may be shown in Table 1.

**Table 1: Combination of an ambient temperature and a supply voltage**

| Ambient temperature | Supply voltage |
|---|---|
| -40°C | 1.50V*L min |
| +125°C | 1.50V*L min |
| -40°C | 5.00V*L |
| +125°C | 5.00V*L |
| +25°C | 3.65V*L |

where L is the quantity of cells, and for example, may be 8, 12, 16, or 18, and may be changed according to a specific hot-plugging test bench requirement, a typical circuit configuration, a battery module, a quantity of cells of each battery module, a CMU configuration requirement, and the like. The quantity L of cells may be selected in cooperation with the quantity of samples and sampling channels of each sample chip, or vice versa.

It may be understood that, the ambient temperature and the supply voltage shown in Table 1 may be referred to as a five-point test. In addition, it may be understood that, the foregoing values of the temperature and the voltage are merely examples, and may be adjusted as required. In other cases, more combinations of an ambient temperature and a supply voltage may be selected. For example, a test at more than five points is performed.

For example, a supply current range test may be performed on the chip. Supply current range verification may be performed on the AFE chip by using the following test method.
a) Place a test sample in a climatic test chamber, and then adjust a temperature of the climatic test chamber to a specified temperature value.
b) Power on the test sample, adjust a cell voltage to a specified value, and check whether a function of the test sample satisfies a specified requirement.
c) Set the test sample to be in a turned-off state after the temperature of the test sample is stable.
d) Remain in the condition for a specified running time.
e) During running, monitor a working current of the test sample in realistic time and record the working current.
f) Repeat the processes a to e, to complete a current test in a sleep state and a running state.
   - sample quantity: 6
   - running time: 15 min
   - For example, refer to Table 1 for a combination of an ambient temperature and a supply voltage.

For example, a cell voltage sampling precision test may be performed on the chip. Cell voltage sampling precision verification may be performed on the AFE chip by using the following test method.
a) Place a test sample in a climatic test chamber, and then adjust a temperature of the climatic test chamber to a specified temperature value.
b) Power on the test sample, adjust a cell voltage to a specified value, and check whether a function of the test sample satisfies a specified requirement.
c) Start reading, after the temperature of the test sample is stable, a cell voltage value collected from the test sample.
d) Compare the voltage value collected from the test sample with a detection device value and record a comparison result.
e) Repeat the processes a to d, to complete voltage sampling precision tests at all set temperatures.
   - sample quantity: 32
   - The sample configuration string quantity may be S. S may be a quantity selected according to an actual scenario and a typical working condition.
   - sample state: sample that has been aged for 1000 h at +125 °C. The aging condition may be an aging condition that can be understood by a person skilled in the art, for example, an aging condition that is set with reference to a related standard.
   - running time: 1 min
   - For example, refer to Table 2 for a combination of an ambient temperature and a supply voltage.

**Table 2: Combination of an ambient temperature and a cell voltage**

| Ambient temperature | Cell voltage value |
|---|---|
| -40°C | 0.5V, 1.5V, 3.0V, 3.3V, 3.6V, 4.25V, 5.0V |
| -20°C | 0.5V, 1.5V, 3.0V, 3.3V, 3.6V, 4.25V, 5.0V |
| 0°C | 0.5V, 1.5V, 3.0V, 3.3V, 3.6V, 4.25V, 5.0V |
| +25°C | 0.5V, 1.5V, 3.0V, 3.3V, 3.6V, 4.25V, 5.0V |
| +65°C | 0.5V, 1.5V, 3.0V, 3.3V, 3.6V, 4.25V, 5.0V |
| +85°C | 0.5V, 1.5V, 3.0V, 3.3V, 3.6V, 4.25V, 5.0V |
| +105°C | 0.5V, 1.5V, 3.0V, 3.3V, 3.6V, 4.25V, 5.0V |
| +125°C | 0.5V, 1.5V, 3.0V, 3.3V, 3.6V, 4.25V, 5.0V |

For example, a cell temperature sampling precision test may be performed on the chip. Cell voltage sampling precision verification may be performed on the AFE chip by using the following test method.
a) Place a test sample in a climatic test chamber, and then adjust a temperature of the climatic test chamber to a specified temperature value.
b) Power on the test sample, adjust a cell voltage to a specified value, and check whether a function of the test sample satisfies a specified requirement.
c) Start reading, after the temperature of the test sample is stable, a temperature sampling line voltage value collected from the test sample.
d) Compare the voltage value collected from the test sample with a detection device value and record a comparison result.
e) Repeat the processes a to d, to complete temperature sampling line voltage value precision tests at all set temperatures.
   - sample quantity: 32;
   - The sample configuration string quantity may be S. S may be a quantity selected according to an actual scenario and a typical working condition.
   - sample state: sample that has been aged for 1000 h at +125 °C. The aging condition may be an aging condition that can be understood by a person skilled in the art, for example, an aging condition that is set with reference to a related standard.
   - running time: 1 min;
   - For example, refer to Table 3 for a combination of an ambient temperature and a supply voltage.

**Table 3: Combination of an ambient temperature and a temperature sampling line input voltage**

| Ambient temperature | Temperature sampling line input voltage value |
|---|---|
| -40°C | 0.5V, 1.5V, 3.0V, 3.3V, 3.6V, 4.25V, 5.0V |
| -20°C | 0.5V, 1.5V, 3.0V, 3.3V, 3.6V, 4.25V, 5.0V |
| 0°C | 0.5V, 1.5V, 3.0V, 3.3V, 3.6V, 4.25V, 5.0V |
| +25°C | 0.5V, 1.5V, 3.0V, 3.3V, 3.6V, 4.25V, 5.0V |
| +65°C | 0.5V, 1.5V, 3.0V, 3.3V, 3.6V, 4.25V, 5.0V |
| +85°C | 0.5V, 1.5V, 3.0V, 3.3V, 3.6V, 4.25V, 5.0V |
| +105°C | 0.5V, 1.5V, 3.0V, 3.3V, 3.6V, 4.25V, 5.0V |
| +125°C | 0.5V, 1.5V, 3.0V, 3.3V, 3.6V, 4.25V, 5.0V |

For example, a leakage current diagnosis threshold test may be performed on the chip. A leakage current diagnosis threshold test may be performed on the AFE chip by using the following test method.
a) Build a simulated test bench for a test sample according to a leakage current diagnosis threshold test requirement.
b) Power on the test sample, adjust a cell voltage to a specified value, and check whether a function of the test sample satisfies a specified requirement.
c) Generate particular waveform interference by using a waveform generator, and apply the particular waveform interference to a corresponding diagnosis channel.
d) Observe a change in a threshold of the diagnosis channel by using an upper computer, and record the change.
e) Repeat the processes c to d, to complete test requirements in remaining channels.
   - sample quantity: 6;
   - The sample configuration string quantity may be S. S may be a quantity selected according to an actual scenario and a typical working condition.
   - sample state: it is verified through a supply voltage range test that the function state satisfies a level requirement.
   - interference waveform parameters: a frequency is 1 kHz to 20 kHz, and an amplitude is ± 300 mV;
   - interference duration: 5 min.

For example, a level definition for the function state is provided. Types of function states of a device under test (DUT) when and after being subjected to electromagnetic interference are defined.
--State A: During the test and after the test ends, all functions and parameters of the DUT meet the requirements of the design specification.
--State B: During the test, all functions of the DUT are normal, but one or more parameter indicators exceed the specification. After the test ends, all parameters automatically restore to specified requirements.
--State C: During the test, one or more functions of the DUT cannot be normally executed. After the test ends, all functions automatically restore to specified requirements.

--State D: During the test, one or more functions of the DUT cannot be normally executed, and cannot automatically restore to specified requirements after the test. A simple operation or reactivation needs to be performed on the DUT.
--State E: During the test, one or more functions of the DUT cannot be normally executed, and cannot automatically restore to specified requirements after the test. The DUT needs to be repaired or replaced.

For example, a level of a function state A of a test in a power-off state/closing state/sleep state is determining by power-on after the test.

as an example, a statement such as "meeting a required level requirement" or "meeting a level requirement" mentioned in the chip function test part in this specification may mean that a sample meets a level of the state A. However, it may be understood that the present disclosure is not limited thereto.

According to the present application, the following examples are further provided:

Example 1 is a test method for a chip, including:
determining a configuration mode of a test circuit, where the test circuit includes at least one chip and at least one battery module, and the at least one chip is configured to be connected to the at least one battery module according to the configuration mode; and
Connect the at least one chip to the at least one battery module based on at least one working condition corresponding to the configuration mode.

Example 2 is the method according to Example 1, further including: testing performance of the at least one chip.

Example 3 is the method according to Example 2, further including: determining, before the testing performance of the at least one chip, whether an operation termination condition is satisfied; and

Test the performance of the at least one chip in response to determining that the operation termination condition is satisfied.

Example 4 is the method according to any one of Examples 1 to 3, where the test circuit further includes a switch matrix, the switch matrix is between the at least one chip and the at least one battery module, and the switch matrix is configured to connect the at least one chip to the at least one battery module according to the configuration mode; and
the connecting the at least one chip to the at least one battery module includes: performing a closing operation used for closing at least two switches in the switch matrix.

Example 5 is the method according to Example 4, where the performing a closing operation used for closing at least two switches in the switch matrix includes closing a switch in the switch matrix based on at least one of the following policies: a first policy, where the first policy is used for preferentially closing two switches of a power-on loop that form a maximum potential difference; or a second policy, where the second policy is used for preferentially closing a switch that is configured to form a path between the at least one battery module.

Example 6 is the method according to Example 4, where the at least one chip includes a first chip, the at least one battery module includes a first battery module, and the determining a configuration mode of a test circuit includes determining that the test circuit is in a first configuration mode, where the first configuration mode indicates that the first chip is configured to be connected to corresponding switches of the switch matrix, to enable sampling channel lines of the first chip to be respectively connected to corresponding sampling leads of the first battery module when the corresponding switches are turned on.

Example 7 is the method according to Example 6, where in response to the determining that the test circuit is in a first configuration mode, the performing the closing operation includes:
closing, if none of switches corresponding to remaining sampling channel lines other than a pair of sampling channel lines associated with a maximum battery potential difference in the first chip is closed, a pair of switches corresponding to the pair of sampling channel lines.

Example 8 is the method according to Example 7, where in response to the determining that the test circuit is in a first configuration mode, the performing the closing operation further includes:
randomly closing the switches corresponding to the remaining sampling channel lines in the first chip after the pair of switches corresponding to the pair of sampling channel lines are closed.

Example 9 is the method according to any one of Examples 6 to 8, where in response to the determining that the test circuit is in a first configuration mode, the performing the closing operation includes: randomly closing a switch corresponding to a sampling channel line of the first chip.

Example 10 is the method according to Example 4, where the at least one chip includes a first chip, the at least one battery module includes at least two battery modules connected in series, and the determining a configuration mode of a test circuit includes determining that the test circuit is in a second configuration mode, where the second configuration mode indicates that the first chip is configured to be connected to corresponding switches of the switch matrix, to enable sampling channel lines of the first chip to be respectively connected to corresponding sampling leads of the at least two battery modules when the corresponding switches are turned on.

Example 11 is the method according to Example 10, where in response to the determining that the test circuit is in a second configuration mode, the performing the closing operation includes:
closing, if none of switches corresponding to sampling leads of a positive-electrode-side battery module of the at least two battery modules is closed, switches corresponding to sampling leads of remaining battery modules other than the positive-electrode-side battery module of the at least two battery modules; and
closing a switch corresponding to a sampling lead associated with a highest battery potential of the positive-electrode-side battery module after the switches corresponding to the sampling leads of the remaining battery modules are closed for a first time delay.

Example 12 is the method according to Example 11, where the performing the closing operation further includes:
randomly closing, after the switch corresponding to the sampling lead associated with the highest battery potential is closed, switches corresponding to remaining sampling leads other than the sampling lead associated with the highest battery potential of the positive-electrode-side battery module.

Example 13 is the method according to any one of Examples 10 to 12, where in response to the determining that the test circuit is in a second configuration mode, the performing the closing operation includes:
closing, if none of switches corresponding to sampling leads of a negative-electrode-side battery module of the at least two battery modules is closed, switches corresponding to sampling leads of remaining battery modules other than the negative-electrode-side battery module of the at least two battery modules; and
closing a switch corresponding to a sampling lead associated with a lowest battery potential of the negative-electrode-side battery module after the switches corresponding to the sampling leads of the remaining battery modules are closed for a second time delay.

Example 14 is the method according to Example 13, where the performing the closing operation further includes:
randomly closing, after the switch corresponding to the sampling lead associated with the lowest battery potential is closed, switches corresponding to remaining sampling leads other than the sampling lead associated with the lowest battery potential of the negative-electrode-side battery module.

Example 15 is the method according to Example 4, where the at least one chip includes a first chip and a second chip, the at least one battery module includes a first battery module, and the determining a configuration mode of a test circuit includes determining that the test circuit is in a third configuration mode, where the third configuration mode indicates that the first chip and the second chip are configured to be connected to corresponding switches of the switch matrix, to enable the first chip and the second chip to be connected to corresponding sampling leads of the first battery module when the corresponding switches are turned on.

Example 16 is the method according to Example 14, where a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and in response to the determining that the test circuit is in a third configuration mode, the performing the closing operation includes:
closing switches corresponding to the first sampling channel line and the second sampling channel line if none of switches corresponding to remaining sampling channel lines of the first chip and the second chip other than the first sampling channel line and the second sampling channel line is closed; and
closing a switch corresponding to the third sampling channel line and a switch corresponding to the fourth sampling channel line after the switches corresponding to the first sampling channel line and the second sampling channel line are closed for a third time delay.

Example 17 is the method according to Example 16, where the performing the closing operation further includes:
randomly closing switches corresponding to remaining sampling channel lines of the first chip and the second chip other than the first sampling channel line, the second sampling channel line, the third sampling channel line, and the fourth sampling channel line after the switch corresponding to the third sampling channel line and the switch corresponding to the fourth sampling channel line are closed.

Example 18 is the method according to any one of Examples 15 to 17, where in response to the determining that the test circuit is in a third configuration mode, the performing the closing operation includes: randomly closing switches corresponding to sampling channel lines of the first chip and the second chip.

Example 19 is the method according to Example 15, where a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and the third configuration mode further indicates that the first sampling channel line is electrically connected to the second sampling channel line.

Example 20 is the method according to Example 19, where in response to the determining that the test circuit is in a third configuration mode, the performing the closing operation includes:
closing switches corresponding to sampling channel lines of the second chip if none of switches corresponding to sampling channel lines of the first chip is closed; and
closing a switch corresponding to the third sampling channel line after the switches corresponding to the sampling channel lines of the second chip are closed for a third time delay.

Example 21 is the method according to Example 20, where the performing the closing operation further includes:
randomly closing switches corresponding to remaining sampling channel lines of the first chip other than the third sampling channel line after the switch corresponding to the third sampling channel line is closed.

Example 22 is the test method according to any one of Examples 3 to 21, where the operation termination condition includes at least one of the following: a quantity of execution times of a closing operation for the at least one chip reaches a first threshold, or a quantity of execution times of a closing operation based on a particular configuration mode reaches a second threshold for the particular configuration mode.

Example 23 is the test method according to any one of Examples 1 to 22, further including:
opening the at least two switches;
determining a current configuration mode between the first chip and the at least one battery module; and
performing a closing operation again based on the current configuration mode.

Example 24 is the test method according to Example 23, further including: performing a discharging operation before the performing a closing operation again based on the current configuration mode.

Example 25 is the method according to any one of Examples 1 to 24, further including: in response to determining that a second operation termination condition is not satisfied:
performing a power-off operation on the at least one chip;
discharging a capacitor in the at least one chip; and
repeatedly performing the steps of performing a closing operation used for closing at least two switches in the switch matrix and testing functions of the at least one chip,
where the second operation termination condition includes at least one of the following: a quantity of execution times of a closing operation for the at least one chip reaches a first threshold, or a quantity of execution times for each working condition of the at least one working condition reaches a second threshold for the working condition.

Example 26 is the method according to any one of Examples 1 to 25, further including: regulating, in response to that the step of determining that the at least one chip is connected to the at least one battery module is performed for the first time, a cell voltage of a battery in the at least one battery module to a specified value before the testing functions of the at least one chip.

Example 27 is the method according to any one of Examples 1 to 26, where the testing performance of the at least one chip includes performing a supply voltage range test on the at least one chip.

Example 28 is a test apparatus for a chip, including:
a switch matrix; and
a control device, where the control device is configured to control an operation on at least one switch in the switch matrix, to perform a power-on operation on at least one chip according to a configuration mode; and
the control device is configured to connect the at least one chip to the at least one battery module based on at least one working condition corresponding to the configuration mode.

Example 29 is the test apparatus according to Example 28, further including at least one battery module, where the performing a power-on operation on at least one chip according to a configuration mode includes connecting the at least one chip to the at least one battery module.

Example 30 is the test apparatus according to Example 29, where the connecting the at least one chip to the at least one battery module includes: performing a closing operation used for closing at least two switches in the switch matrix.

Example 31 is the test apparatus according to Example 30, where the performing a closing operation used for closing at least two switches in the switch matrix includes closing a switch in the switch matrix based on at least one of the following policies: a first policy, where the first policy is used for preferentially closing two switches of a power-on loop that form a maximum potential difference; or a second policy, where the second policy is used for preferentially closing a switch that is configured to form a path between the at least one battery module.

Example 32 is the test apparatus according to any one of Examples 28 to 31, where the test apparatus includes an interface configured to connect to the at least one chip.

Example 33 is the test apparatus according to any one of Examples 28 to 31, where the control device includes an upper computer.

Example 34 is the test apparatus according to any one of Examples 28 to 31, further including at least one discharging unit, where the at least one discharging unit is configured to discharge a corresponding capacitor in the at least one chip when the at least one discharging unit is switched on.

Example 35 is an upper computer, where the upper computer is configured to control an operation on at least one switch in a switch matrix, the switch matrix is configured to connect at least one chip to at least one battery module, and the upper computer is configured to perform the method according to any one of Examples 1 to 27.

Example 36 is a chip for a battery, where the chip is tested by using the method according to any one of Examples 1 to 27.

Example 37 is an electronic device, including: at least one processor; and
a memory communicatively connected to the at least one processor, where
the memory stores an instruction executable by the at least one processor, and the instruction is executed by the at least one processor, to enable the at least one processor to perform the method according to any one of Examples 1 to 27.

Example 38 is a non-transitory computer-readable storage medium storing a computer instruction, where the computer instruction is used for causing the computer to perform the method according to any one of Examples 1 to 27.

In conclusion, it should be noted that the foregoing embodiments are for description of the technical solutions of the present application only rather than for limiting the present application. Although the present application has been described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of the present application. All such modifications and equivalent replacements shall fall within the scope of claims and specification of the present application. Especially, as long as no structural conflict is caused, various technical features mentioned in various embodiments may be combined freely. The present application is not limited to the specific embodiments disclosed herein, but includes all technical solutions falling within the scope of the claims.

## Claims

1. A test method for a chip, comprising:
determining a configuration mode of a test circuit, wherein the test circuit comprises at least one chip and at least one battery module, and the at least one chip is configured to be connected to the at least one battery module according to the configuration mode; and
connecting the at least one chip to the at least one battery module based on at least one working condition corresponding to the configuration mode.

2. The method according to claim 1, further comprising: testing performance of the at least one chip.

3. The method according to claim 2, further comprising: determining, before the testing performance of the at least one chip, whether an operation termination condition is satisfied; and
testing the performance of the at least one chip in response to determining that the operation termination condition is satisfied.

4. The method according to any one of claims 1 to 3, wherein the test circuit further comprises a switch matrix, the switch matrix is between the at least one chip and the at least one battery module, and the switch matrix is configured to connect the at least one chip to the at least one battery module according to the configuration mode; and
the connecting the at least one chip to the at least one battery module comprises: performing a closing operation used for closing at least two switches in the switch matrix.

5. The method according to claim 4, wherein the performing a closing operation used for closing at least two switches in the switch matrix comprises closing a switch in the switch matrix based on at least one of the following policies: a first policy, wherein the first policy is used for preferentially closing two switches of a power-on loop that form a maximum potential difference; or a second policy, wherein the second policy is used for preferentially closing a switch that is configured to form a path between the at least one battery module.

6. The method according to claim 4, wherein the at least one chip comprises a first chip, the at least one battery module comprises a first battery module, and the determining a configuration mode of a test circuit comprises determining that the test circuit is in a first configuration mode, wherein the first configuration mode indicates that the first chip is configured to be connected to corresponding switches of the switch matrix, to enable sampling channel lines of the first chip to be respectively connected to corresponding sampling leads of the first battery module when the corresponding switches are turned on.

7. The method according to claim 6, wherein in response to the determining that the test circuit is in a first configuration mode, the performing the closing operation comprises:
closing, if none of switches corresponding to remaining sampling channel lines other than a pair of sampling channel lines associated with a maximum battery potential difference in the first chip is closed, a pair of switches corresponding to the pair of sampling channel lines.

8. The method according to claim 7, wherein in response to the determining that the test circuit is in a first configuration mode, the performing the closing operation further comprises:
randomly closing the switches corresponding to the remaining sampling channel lines in the first chip after the pair of switches corresponding to the pair of sampling channel lines are closed.

9. The method according to any one of claims 6 to 8, wherein in response to the determining that the test circuit is in a first configuration mode, the performing the closing operation comprises: randomly closing a switch corresponding to a sampling channel line of the first chip.

10. The method according to claim 4, wherein the at least one chip comprises a first chip, the at least one battery module comprises at least two battery modules connected in series, and the determining a configuration mode of a test circuit comprises determining that the test circuit is in a second configuration mode, wherein the second configuration mode indicates that the first chip is configured to be connected to corresponding switches of the switch matrix, to enable sampling channel lines of the first chip to be respectively connected to corresponding sampling leads of the at least two battery modules when the corresponding switches are turned on.

11. The method according to claim 10, wherein in response to the determining that the test circuit is in a second configuration mode, the performing the closing operation comprises:
closing, if none of switches corresponding to sampling leads of a positive-electrode-side battery module of the at least two battery modules is closed, switches corresponding to sampling leads of remaining battery modules other than the positive-electrode-side battery module of the at least two battery modules; and
closing a switch corresponding to a sampling lead associated with a highest battery potential of the positive-electrode-side battery module after the switches corresponding to the sampling leads of the remaining battery modules are closed for a first time delay.

12. The method according to claim 11, wherein the performing the closing operation further comprises:
randomly closing, after the switch corresponding to the sampling lead associated with the highest battery potential is closed, switches corresponding to remaining sampling leads other than the sampling lead associated with the highest battery potential of the positive-electrode-side battery module.

13. The method according to any one of claims 10 to 12, wherein in response to the determining that the test circuit is in a second configuration mode, the performing the closing operation comprises:
closing, if none of switches corresponding to sampling leads of a negative-electrode-side battery module of the at least two battery modules is closed, switches corresponding to sampling leads of remaining battery modules other than the negative-electrode-side battery module of the at least two battery modules; and
closing a switch corresponding to a sampling lead associated with a lowest battery potential of the negative-electrode-side battery module after the switches corresponding to the sampling leads of the remaining battery modules are closed for a second time delay.

14. The method according to claim 13, wherein the performing the closing operation further comprises:
randomly closing, after the switch corresponding to the sampling lead associated with the lowest battery potential is closed, switches corresponding to remaining sampling leads other than the sampling lead associated with the lowest battery potential of the negative-electrode-side battery module.

15. The method according to claim 4, wherein the at least one chip comprises a first chip and a second chip, the at least one battery module comprises a first battery module, and the determining a configuration mode of a test circuit comprises determining that the test circuit is in a third configuration mode, wherein the third configuration mode indicates that the first chip and the second chip are configured to be connected to corresponding switches of the switch matrix, to enable the first chip and the second chip to be connected to corresponding sampling leads of the first battery module when the corresponding switches are turned on.

16. The method according to claim 14, wherein a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and in response to the determining that the test circuit is in a third configuration mode, the performing the closing operation comprises:
closing switches corresponding to the first sampling channel line and the second sampling channel line if none of switches corresponding to remaining sampling channel lines of the first chip and the second chip other than the first sampling channel line and the second sampling channel line is closed; and
closing a switch corresponding to the third sampling channel line and a switch corresponding to the fourth sampling channel line after the switches corresponding to the first sampling channel line and the second sampling channel line are closed for a third time delay.

17. The method according to claim 16, wherein the performing the closing operation further comprises:
randomly closing switches corresponding to remaining sampling channel lines of the first chip and the second chip other than the first sampling channel line, the second sampling channel line, the third sampling channel line, and the fourth sampling channel line after the switch corresponding to the third sampling channel line and the switch corresponding to the fourth sampling channel line are closed.

18. The method according to any one of claims 15 to 17, wherein in response to the determining that the test circuit is in a third configuration mode, the performing the closing operation comprises: randomly closing switches corresponding to sampling channel lines of the first chip and the second chip.

19. The method according to claim 15, wherein a first sampling channel line of the first chip and a second sampling channel line of the second chip are configured to be connected to a first sampling lead and a second sampling lead of the first battery module that are adjacent to each other, a third sampling channel line of the first chip and a fourth sampling channel line of the second chip are configured to be connected to a third sampling lead and a fourth sampling lead of the first battery module that are associated with a maximum battery potential difference, and the third configuration mode further indicates that the first sampling channel line is electrically connected to the second sampling channel line.

20. The method according to claim 19, wherein in response to the determining that the test circuit is in a third configuration mode, the performing the closing operation comprises:
closing switches corresponding to sampling channel lines of the second chip if none of switches corresponding to sampling channel lines of the first chip is closed; and
closing a switch corresponding to the third sampling channel line after the switches corresponding to the sampling channel lines of the second chip are closed for a third time delay.

21. The method according to claim 20, wherein the performing the closing operation further comprises:
randomly closing switches corresponding to remaining sampling channel lines of the first chip other than the third sampling channel line after the switch corresponding to the third sampling channel line is closed.

22. The test method according to any one of claims 3 to 21, wherein the operation termination condition comprises at least one of the following: a quantity of execution times of a closing operation for the at least one chip reaches a first threshold, or a quantity of execution times of a closing operation based on a particular configuration mode reaches a second threshold for the particular configuration mode.

23. The test method according to any one of claims 1 to 22, further comprising:
opening the at least two switches;
determining a current configuration mode between the first chip and the at least one battery module; and
performing a closing operation again based on the current configuration mode.

24. The test method according to claim 23, further comprising: performing a discharging operation before the performing a closing operation again based on the current configuration mode.

25. The method according to any one of claims 1 to 24, further comprising: in response to determining that a second operation termination condition is not satisfied:
performing a power-off operation on the at least one chip;
discharging a capacitor in the at least one chip; and
repeatedly performing the steps of performing a closing operation used for closing at least two switches in the switch matrix and testing functions of the at least one chip,
wherein the second operation termination condition comprises at least one of the following: a quantity of execution times of a closing operation for the at least one chip reaches a first threshold, or a quantity of execution times for each working condition of the at least one working condition reaches a second threshold for the working condition.

26. The method according to any one of claims 1 to 25, further comprising: regulating, in response to that the step of determining that the at least one chip is connected to the at least one battery module is performed for the first time, a cell voltage of a battery in the at least one battery module to a specified value before the testing functions of the at least one chip.

27. The method according to any one of claims 1 to 26, wherein the testing performance of the at least one chip comprises performing a supply voltage range test on the at least one chip.

28. A test apparatus for a chip, comprising:
a switch matrix; and
a control device, wherein the control device is configured to control an operation on at least one switch in the switch matrix, to perform a power-on operation on at least one chip according to a configuration mode; and
the control device is configured to connect the at least one chip to the at least one battery module based on at least one working condition corresponding to the configuration mode.

29. The test apparatus according to claim 28, further comprising at least one battery module, wherein the performing a power-on operation on at least one chip according to a configuration mode comprises connecting the at least one chip to the at least one battery module.

30. The test apparatus according to claim 29, wherein the connecting the at least one chip to the at least one battery module comprises: performing a closing operation used for closing at least two switches in the switch matrix.

31. The test apparatus according to claim 30, wherein the performing a closing operation used for closing at least two switches in the switch matrix comprises closing a switch in the switch matrix based on at least one of the following policies: a first policy, wherein the first policy is used for preferentially closing two switches of a power-on loop that form a maximum potential difference; or a second policy, wherein the second policy is used for preferentially closing a switch that is configured to form a path between the at least one battery module.

32. The test apparatus according to any one of claims 28 to 31, wherein the test apparatus comprises an interface configured to connect to the at least one chip.

33. The test apparatus according to any one of claims 28 to 31, wherein the control device comprises an upper computer.

34. The test apparatus according to any one of claims 28 to 31, further comprising at least one discharging unit, wherein the at least one discharging unit is configured to discharge a corresponding capacitor in the at least one chip when the at least one discharging unit is switched on.

35. An upper computer, wherein the upper computer is configured to control an operation on at least one switch in a switch matrix, the switch matrix is configured to connect at least one chip to at least one battery module, and the upper computer is configured to perform the method according to any one of claims 1 to 27.

36. A chip for a battery, wherein the chip is tested by using the method according to any one of claims 1 to 27.

37. An electronic device, comprising: at least one processor; and
a memory communicatively connected to the at least one processor, wherein
the memory stores an instruction executable by the at least one processor, and the instruction is executed by the at least one processor, to enable the at least one processor to perform the method according to any one of claims 1 to 27.

38. A non-transitory computer-readable storage medium storing a computer instruction, wherein the computer instruction is used for causing the computer to perform the method according to any one of claims 1 to 27.
